# EUROPEAN PATENT APPLICATION

(11) **EP 4 835 575 A1**
(43) Date of publication of application: **04.11.2026**
(21) Application number: 24913087.3
(22) Date of filing: 27.12.2024
(51) Int. Cl.: G03F 7/095, B41C 1/055, B41N 1/12, G03F 7/00, G03F 7/20

(54) **METHOD FOR MANUFACTURING PRINTING PLATE**

(30) Priority: 27.12.2023 JP 2023220270
(71) Applicant: ASAHI KASEI KABUSHIKI KAISHA, Tokyo 100-0006 (JP)
(72) Inventor: IDO, Shinji, Tokyo 100-0006 (JP); SAEKI, Keiichiro, Tokyo 100-0006 (JP); ISHII, Takumi, Tokyo 100-0006 (JP)
(74) Representative: Strehl & Partner mbB
(86) International application number: PCT/JP2024/046350
(87) International publication number: WO 2025/143201

(57) **Abstract**

A method for producing a printing plate, including:
a stacking step of sequentially stacking, on a first hard plate 11 positioned below, a negative film 1 having a microcell pattern, a liquid photosensitive resin composition layer 2, a support 3, and a second hard plate 12 positioned above; and
an exposure step of performing irradiation with an active ray from the first hard plate 11 side and the second hard plate 12 side to cure the photosensitive resin composition layer 2,
wherein, in the stacking step, the photosensitive resin composition layer 2 is directly stacked on the negative film 1, and
wherein a solubility parameter SpA of a photosensitive resin composition constituting the photosensitive resin composition layer 2 and a solubility parameter SpB of the negative film have a relationship of the following expression (I): $\left|SpA-SpB\right| \geq 2.0$ (I).

## Description

### Technical Field

The present invention relates to a method for producing a printing plate.

### Background Art

In recent years, flexographic printing using flexographic printing plates has been widely employed as a method for printing various media such as corrugated board, paper, and films.

For flexographic printing plates, a variety of production methods have conventionally been proposed (see, for example, Patent Literature 1).

Patent Literature 1 discloses, as a method for producing a flexographic printing plate, the following method.

First, a negative film on which a desired pattern has been formed and a transparent protective film are stacked on a hard plate positioned below, a liquid photosensitive resin composition layer is stacked on the transparent protective film, a support is stacked as necessary, and a hard plate positioned above is further stacked, and the photosensitive resin composition layer sandwiched between the lower stacked plate and the upper stacked plate is controlled to have a desired uniform thickness.

Subsequently, ultraviolet exposure (back exposure) is carried out on the photosensitive resin composition layer from the upper hard plate side corresponding to the hard plate positioned above, and ultraviolet irradiation is carried out through the negative film and the transparent protective film from a surface side of the photosensitive resin composition layer in an uncured state on the side opposite to the ultraviolet-exposed surface, that is, from the lower hard plate side corresponding to the hard plate positioned below, to carry out relief exposure, thereby obtaining an original flexographic printing plate.

The photosensitive resin composition of the unexposed portion of the original flexographic printing plate is removed for development by washing, for example, so that a relief image is formed to obtain a flexographic printing plate.

A method for producing a flexographic printing plate using a liquid photosensitive resin composition as described above allows recovery of the photosensitive resin composition in an unexposed portion, and can achieve both a reduction in the amount of the photosensitive resin composition to be discarded and a reduction in production costs for the flexographic printing plate, and therefore has been prevalent as a method for producing a flexographic printing plate with high environmental adaptability.

Meanwhile, "solid density" is known as an index of the appearance of printed matter using a flexographic printing plate. In general, a higher solid density is preferable, and in order to improve the solid density, a technique of forming "microcells" on a surface of the flexographic printing plate is known (see, for example, Patent Literature 2).

In recent years, the CTP (Computer To Plate) technique has also become known with regard to the method for producing a flexographic printing plate.

In the CTP technique, an ablation layer that can be ablated by an infrared ray is established on top of the photosensitive resin composition layer, and the ablation layer is removed in a desired shape by irradiating it with an infrared laser to form an active ray transmitting portion that corresponds to a negative. Next, the photosensitive resin composition layer is irradiated with an ultraviolet ray using the ablation layer as a mask to allow the photosensitive resin composition to react in the same shape as the active ray transmitting portion formed in the ablation layer and to undergo relief exposure, and finally, the ablation layer and the unexposed portion of the photosensitive resin composition that are no longer needed are developed and removed to produce a flexographic printing plate.

However, in the method for producing a flexographic printing plate as described above, there is a problem that it is difficult to isolate and recover the photosensitive resin composition in the unexposed portion after the relief exposure since the ablation layer and the photosensitive resin composition are designed to have high adhesion from the viewpoint of ensuring practicality. In addition, elution and migration of the ablation layer to the photosensitive resin composition cannot be fully suppressed, posing the problem that not only is it difficult to isolate and recover the photosensitive resin composition in the unexposed portion, but also there is room for improvement in terms of ensuring the quality of the flexographic printing plate.

Here, "elution" refers to the components constituting the ablation layer being individually mixed into the photosensitive resin composition, and "migration" refers to the ablation layer being peeled off from the base material while maintaining its film shape and mixed into the photosensitive resin composition.

As a countermeasure to the above-described problems caused by adhesion, elution, and migration of the ablation layer to the photosensitive resin composition, there is proposed a method in which an image mask is formed by irradiating with an infrared laser an original flexographic printing plate having a photosensitive resin composition layer, a film layer, and an optical density varying layer corresponding to an ablation layer on a predetermined support (see, for example, Patent Literature 3). In addition, as a technique relating to a method for forming an article having a relief image using a predetermined removable film, there is proposed a method in which an image-forming film containing an image-forming material is imagewise exposed to image-forming radiation to obtain an image-formed film, the image-formed film is laminated on an image-forming article including a photosensitive material and a release layer, which is irradiated with curing radiation through the image-formed film, the image-formed film is removed from the image-forming article, and thereafter the image-forming article is developed to form a relief image (see, for example, Patent Literature 4).

In these methods, the whole surface is exposed to an ultraviolet ray from above the image mask, then the image mask is peeled off and removed together with the film layer or the release layer, and then development is further performed to obtain a flexographic printing plate. In these methods, since the image mask is removed before development, there is an advantage that adhesion, elution, and migration to the photosensitive resin composition layer can be suppressed.

### Citation List

### Patent Literature

Patent Literature 1: Japanese Patent Laid-Open No. 2005-301071
Patent Literature 2: Japanese Translation of PCT International Application Publication No. 2021-525661
Patent Literature 3: International Publication No. WO 01/18605
Patent Literature 4: Japanese Patent No. 4971311

### Summary of Invention

### Technical Problem

However, a problem of the methods for producing a flexographic printing plate proposed in Patent Literatures 1, 3, and 4 is that refraction or scattering of the ultraviolet ray is more likely to occur due to the film layer or the release layer present between the photosensitive resin composition layer and the negative film or the image mask, resulting in reduced image reproducibility. In particular, as described above, when microcells are formed on a surface of a flexographic printing plate in order to increase the solid density of a printed matter, a problem is that refraction or scattering of the ultraviolet ray due to the film layer or the release layer deteriorates formability of the microcells, ultimately causing a reduction in quality of the finally obtained printing plate.

Meanwhile, when no film layer or release layer is provided between the photosensitive resin composition layer and the negative film or the image mask, a problem is that adhesive force between the photosensitive resin composition layer and the negative film or the image mask becomes excessive, and elution and migration between the layers cannot be avoided.

In view of the above-described problems of the conventional techniques, an object of the present invention is to provide a method for producing a printing plate that suppresses elution and migration of a negative film to a photosensitive resin composition layer, and that enables production of a printing plate on which microcells can be formed and that has high solid density and excellent image reproducibility.

### Solution to Problem

The present inventors have conducted diligent studies in order to solve the problems and have found that the above-described problems can be solved by directly stacking a liquid photosensitive resin composition layer and a negative film to carry out pattern exposure, and specifying the absolute value of the difference between the solubility parameter of the photosensitive resin composition and the solubility parameter of the negative film to a predetermined value or more, and thereby completed the present invention.

That is, the present invention is as follows.
[1] A method for producing a printing plate, comprising:
   a stacking step of sequentially stacking, on a first hard plate positioned below, a negative film having a microcell pattern, a liquid photosensitive resin composition layer, a support, and a second hard plate positioned above; and
   an exposure step of performing irradiation with an active ray from the first hard plate side and the second hard plate side to cure the photosensitive resin composition layer,
   wherein, in the stacking step, the photosensitive resin composition layer is directly stacked on the negative film, and
   wherein a solubility parameter SpA of a photosensitive resin composition constituting the photosensitive resin composition layer and a solubility parameter SpB of the negative film have a relationship of the following expression (I): $\left|SpA-SpB\right| \geq 2.0$ (I).
[2] The method for producing a printing plate according to [1],
   wherein the method further comprises, as a step preceding the stacking step, a drawing step of forming a microcell pattern on the negative film, and
   wherein, in the drawing step, at least one selected from the group consisting of an ablation method, a thermal method, an ink jet method, and a silver salt method is used.
[3] The method for producing a printing plate according to [1] or [2],
   wherein a solubility parameter SpA of a photosensitive resin composition constituting the photosensitive resin composition layer is 10.0 or more and 14.0 or less.
[4] The method for producing a printing plate according to any one of [1] to [3],
   wherein a solubility parameter SpB of the negative film is more than 14.0.
[5] The method for producing a printing plate according to any one of [1] to [3],
   wherein a solubility parameter SpB of the negative film is less than 10.0.
[6] The method for producing a printing plate according to any one of [1] to [5],
   wherein the negative film contains a resin having a constituent unit represented by the following general formula (II): 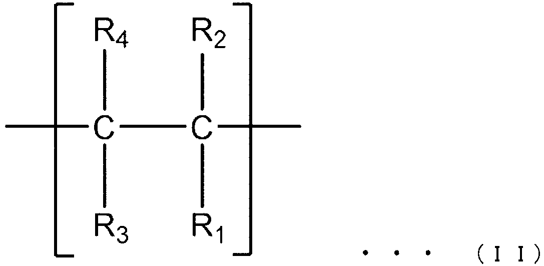
   wherein, in the formula (II), R₁ and R₂ each independently represent a non-polar group, and R₃ and R₄ each independently represent a hydrogen atom or a non-polar group.
[7] The method for producing a printing plate according to [6], wherein
   in the formula (II), R₁ and R₂ each independently represent any one selected from the group consisting of an alkyl group, an alkenyl group, and an alkynyl group, and
   R₃ and R₄ are each independently any one selected from the group consisting of a hydrogen atom, an alkyl group, an alkenyl group, and an alkynyl group.
[8] The method for producing a printing plate according to [6] or [7], wherein
   in the formula (II), R₁ and R₂ are each independently an alkyl group, and
   R₃ and R₄ are each independently a hydrogen atom or an alkyl group.
[9] The method for producing a printing plate according to any one of [6] to [8],
   wherein the resin having a constituent unit represented by the general formula (II) further has a constituent unit derived from a monovinyl-substituted aromatic hydrocarbon.
[10] The method for producing a printing plate according to any one of [1] to [9],
   wherein the negative film contains at least one selected from the group consisting of polyurethane, polylactic acid, polycarbonate, polyester, polyamide, polybutyral, polyvinyl alcohol, poly(meth)acrylate, and modified products or partially saponified products thereof.
[11] The method for producing a printing plate according to any one of [1] to [10],
   wherein the method comprises, as a step succeeding the exposure step, a developing step of removing an unexposed portion of the photosensitive resin composition layer, and
   wherein the method further comprises a recovery step of recovering the unexposed portion removed in the developing step for use as a photosensitive resin composition for producing a new printing plate.
[12] A method for producing a printing plate, comprising:
   a stacking step of sequentially stacking, on a first hard plate positioned below, a negative film having a microcell pattern, a liquid photosensitive resin composition layer, a support, and a second hard plate positioned above; and
   an exposure step of performing irradiation with an active ray from the first hard plate side and the second hard plate side to cure the photosensitive resin composition layer,
   wherein, in the stacking step, the photosensitive resin composition layer is directly stacked on the negative film, and
   wherein a solubility parameter SpB of the negative film is 13.0 or more.
[13] A method for producing a printing plate, comprising:
   a stacking step of sequentially stacking, on a first hard plate positioned below, a negative film having a microcell pattern, a liquid photosensitive resin composition layer, a support, and a second hard plate positioned above; and
   an exposure step of performing irradiation with an active ray from the first hard plate side and the second hard plate side to cure the photosensitive resin composition layer,
   wherein, in the stacking step, the photosensitive resin composition layer is directly stacked on the negative film, and
   wherein a solubility parameter SpB of the negative film is 9.0 or less.

### Advantageous Effect of Invention

The present invention can provide a method for producing a printing plate that suppresses elution and migration of a negative film to a photosensitive resin composition layer, and that can provide a printing plate on which microcells can be formed and that has high solid density and excellent image reproducibility.

### Brief Description of Drawings

[Figure 1] Figure 1 shows a schematic configuration diagram illustrating a method for producing a flexographic printing plate of the present invention.
[Figure 2] Figure 2 shows a schematic cross-sectional view of an example of a negative film used in a method for producing a printing plate of the present invention.

### Description of Embodiments

Hereinafter, an embodiment for carrying out the present invention (hereinafter, referred to as "present embodiment") will be described in detail.

The present embodiment given below is an illustration for describing the present invention and does not intend to limit the present invention to the contents given below.

The present invention can be carried out through appropriate changes or modifications without departing from the spirit of the present invention.

### [Method for Producing Printing Plate]

A method for producing a printing plate according to the present embodiment includes: a stacking step of sequentially stacking, on a first hard plate positioned below, a negative film having a microcell pattern, a liquid photosensitive resin composition layer, a support, and a second hard plate positioned above; and an exposure step of performing irradiation with an active ray from the first hard plate side and the second hard plate side to cure the photosensitive resin composition layer,

In the stacking step, the photosensitive resin composition layer is directly stacked on the negative film.

The solubility parameter SpA of a photosensitive resin composition constituting the photosensitive resin composition layer and the solubility parameter SpB of the negative film have a relationship of the following expression (I): $\left|SpA-SpB\right| \geq 2.0$ (I).

The method for producing a printing plate according to the present embodiment can suppress elution and migration of a negative film to a photosensitive resin composition layer, and can provide a flexographic printing plate on which microcells can be formed and that has high solid density and excellent image reproducibility.

### (Stacking Step)

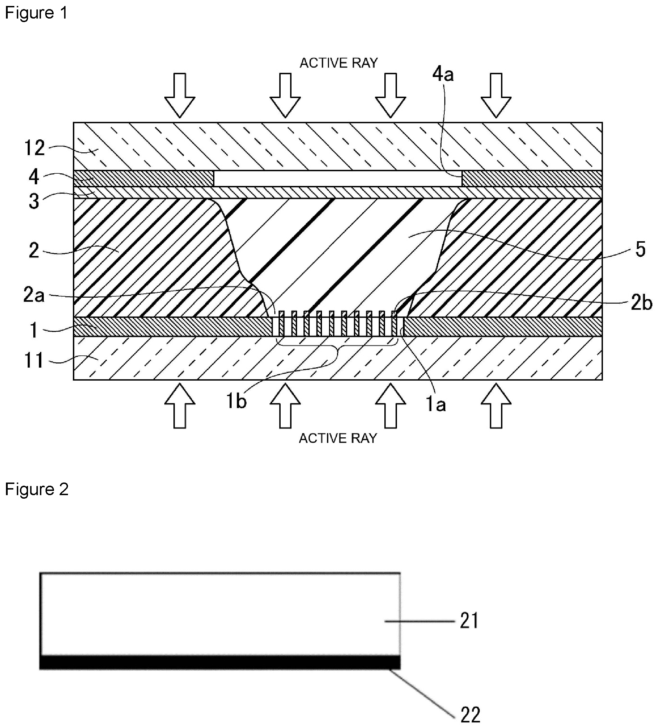

Figure 1 shows a schematic cross-sectional view for illustrating the method for producing a printing plate according to the present embodiment.

In the stacking step, on a first hard plate 11 positioned below, a negative film 1 having a predetermined pattern 1a for forming a desired printing pattern and a predetermined microcell pattern 1b for forming microcells in a finally obtained printing plate, a liquid photosensitive resin composition layer 2, a support 3, and a second hard plate 12 positioned above are sequentially stacked.

Note that a negative film for back exposure 4 having a pattern 4a for forming a shelf layer in back exposure may be provided between the photosensitive resin composition layer 2 and the second hard plate 12.

In the method for producing a printing plate according to the present embodiment, the liquid photosensitive resin composition layer 2 is directly stacked on the negative film 1 in the stacking step, without interposing a cover film or the like. Due to this, refraction or scattering of exposure light in the exposure step can be prevented, and high image reproducibility can be obtained.

### <Hard Plate>

As the first hard plate 11 and the second hard plate 12 used in the method for producing a printing plate according to the present embodiment, ultraviolet transmitting glass plates or the like known for use in production of flexographic printing plates can be used.

### <Negative Film>

The negative film 1 used in the method for producing a printing plate according to the present embodiment has a predetermined printing pattern 1a for forming a desired relief, and a predetermined microcell pattern 1b for forming microcells.

### [Microcell Pattern]

As a method for improving solid density in a printing plate, a method in which the surface area of a letterpress printing plate is increased is effective. In order to improve solid density by uniformly and densely covering a printing plate with ink, a technique in which microcells are formed on a surface of the printing plate is known. For example, various microcell patterns such as those disclosed in Japanese Translation of PCT International Application Publication No. 2021-525661 are used. Specifically, by providing microcells of various shapes such as dot shapes, grid shapes, halftone dot shapes, line shapes, and the like on a surface of a printing plate as fine uneven shapes, the surface area of the printing plate surface can be increased.

Note that the microcell pattern can be used not only in a solid area for improving solid density of printed ink, but also for characters, line drawings, and halftones, that is, for all kinds of image elements for which improvement of ink transfer characteristics is achieved. The microcell pattern is usually not visually recognizable in a final printed matter, but as a result forms a surface structure that improves spreading of ink.

The method for producing a printing plate according to the present embodiment preferably includes, as a step preceding the stacking step, a drawing step of forming a predetermined microcell pattern on the negative film 1. The microcell pattern is preferably formed in a desired area so that it can be applied to a printing area of any size and a uniform solid area can be printed.

The drawing step for forming a microcell pattern is not limited to the following, but can be performed by, for example, an ablation method, a thermal method, an ink jet method, a silver salt method, or the like. Specifically, when the negative film 1 has a configuration having an ablation layer on a predetermined base material, drawing processing can be performed by irradiating the ablation layer with an infrared ray. The drawing and processing method is not particularly limited, and can be carried out using a known irradiation unit. The ablation layer is irradiated with an infrared laser to decompose the resin of the irradiated part of the infrared ray, and the pattern is drawn and processed. As a result, an ablation layer on which the pattern has been drawn and processed is obtained.

Examples of the infrared laser include ND/YAG laser (for example, 1064 nm) or diode laser (for example, 830 nm). Laser systems suitable for CTP plate making techniques are sold on the market, and, for example, a diode laser system CDI Spark (Esko-Graphics BV.) can be used. This laser system includes: a rotary cylindrical drum that holds the negative film; an IR laser irradiation apparatus; and a layout computer, and image information is directly sent from the layout computer to the laser apparatus.

By the negative film 1 having the microcell pattern 1b, a printing plate obtained by the method for producing a printing plate according to the present embodiment becomes, for example, one in which a letterpress surface has a pattern 2a including a plurality of microcells 2b that are fine uneven portions each having a predetermined area and height and are formed derived from the negative film 1.

In the method for producing a printing plate according to the present embodiment, by using the negative film 1 having the microcell pattern 1b, improvement of solid density can be achieved.

### [Relational Expression of Solubility Parameters]

In the method for producing a printing plate according to the present embodiment, the solubility parameter SpA of a photosensitive resin composition constituting the photosensitive resin composition layer, which will be described later, and the solubility parameter SpB of the negative film have a relationship of the following expression (I): $\left|SpA-SpB\right| \geq 2.0$ (I).

That is, the absolute value of the difference between SpA and SpB is 2.0 or more. It is preferably 2.1 or more, and more preferably 2.2 or more. Both a case where SpB is larger than SpA and a case where SpB is smaller than SpA are possible.

By the absolute value of the difference between SpA and SpB being 2.0 or more, even when the negative film and the liquid photosensitive resin composition are directly stacked, elution and migration of the negative film to the photosensitive resin composition can be effectively suppressed.

Note that the upper limit value of the absolute value of the difference between SpA and SpB is determined by materials of the negative film and the photosensitive resin composition layer to be selected, and is 13.0 or less from a practical viewpoint.

As described above, in the present embodiment, since elution and migration of the negative film to the photosensitive resin composition layer can be suppressed, isolation and recovery of the photosensitive resin composition in an unexposed portion become easy, and improvement in quality of the printing plate can be achieved.

Furthermore, by being able to suppress elution and migration of the negative film to the photosensitive resin composition layer, it is not necessary to provide a predetermined film layer between the negative film and the photosensitive resin composition layer, refraction or scattering of the ultraviolet ray caused by providing the film layer can be prevented, and excellent image reproducibility can be realized. In particular, in the method for producing a printing plate according to the present embodiment, since the negative film has a microcell pattern, being able to avoid providing a predetermined film layer between the negative film and the photosensitive resin composition layer is extremely effective from the viewpoint of microcell formability and improvement in quality of the finally obtained printing plate.

In general, a solubility parameter (Sp value) is defined as shown in the following expression (1): $Sp value \left(δ\right) = {\left(ΔE/V\right)}^{1 / 2} \left[{\left({cal / cm}^{3}\right)}^{1 / 2}\right]$ (1).

Here, V is a molar molecular volume of an organic solvent, and ΔE is a cohesive energy (evaporation energy).

The molar molecular volume and the cohesive energy of an organic solvent can also be determined from known values, for example, as described in the literature "POLYMER ENGINEERING AND SCIENCE, Vol. 14, 147-154, 1974".

On the other hand, when the above parameters are not known, they can be actually measured by using a method called a cloud point titration method.

Specifically, first, to a solution obtained by dissolving a sample with an unknown SP value in a good solvent with a known SP value, a poor solvent having an SP value lower than that of the good solvent is added dropwise, and the volume of the poor solvent at which the solute starts to precipitate is measured. Subsequently, to a newly prepared solution obtained by dissolving the sample with an unknown SP value in the good solvent with a known SP value, a poor solvent having an SP value higher than that of the good solvent is added dropwise, and the volume of the poor solvent at which the solute starts to precipitate is measured. By applying the respective volumes of the poor solvents determined here to the following expression (2), an SP value (δ) can be determined: $SP value \left(δ\right) = \left({{V}_{ml}}^{1 / 2}⋅{δ}_{ml}+{{V}_{mh}}^{1 / 2}⋅{δ}_{mh}\right) / \left({{V}_{ml}}^{1 / 2}+{{V}_{mh}}^{1 / 2}\right)$ (2).

Here, Vₘₗ is the volume of the poor solvent having a lower SP value, Vₘₕ is the volume of the poor solvent having a higher SP value, δₘₗ is the SP value of the poor solvent having a lower SP value, and δₘₕ is the SP value of the poor solvent having a higher SP value.

All SP values described in Examples, which will be described later, use values actually measured by the cloud point titration method.

The absolute value of the difference between the solubility parameter (SpB) of the negative film used in the present embodiment, and the solubility parameter (SpA) of the photosensitive resin composition can be controlled within the above-described numerical range by selecting a combination of the negative film and the photosensitive resin composition each having an appropriate solubility parameter.

Specifically, by selecting, as a material of the negative film, at least one selected from the group consisting of a resin having a constituent unit represented by a general formula (II), which will be described later, polyurethane, polylactic acid, polycarbonate, polyester, polyamide, polybutyral, polyvinyl alcohol, poly(meth)acrylate, and modified products or partially saponified products thereof, and selecting, as a material of the photosensitive resin composition, a photosensitive material containing a polymer (b-1), an ethylenically unsaturated compound (b-2), and a photopolymerization initiator (b-3), which will be described later, the absolute value of the difference from the solubility parameter (SpA) of the photosensitive resin composition can be controlled to be 2.0 or more.

Note that, in calculation of the SP value, the following good solvents and poor solvents, and their respective SP values, can be used.

### Good solvents:

toluene (SP value: 8.9 [(cal/cm³)^{1/2}])
p-xylene (SP value: 8.7 [(cal/cm³)^{1/2}])
butyl acetate (SP value: 8.5 [(cal/cm³)^{1/2}])
ethyl acetate (SP value: 9.1 [(cal/cm³)^{1/2}])
acetone (SP value: 9.8 [(cal/cm³)^{1/2}])

### Poor solvents:

n-hexane (SP value: 7.2 [(cal/cm³)^{1/2}])
ethanol (SP value: 12.9 [(cal/cm³)^{1/2}])
water (SP value: 23.4 [(cal/cm³)^{1/2}])

The solubility parameter SpA of a photosensitive resin composition constituting the photosensitive resin composition layer, which will be described later, is usually specified by materials that are used as photosensitive resin compositions for producing flexographic printing plates. From a practical viewpoint, the solubility parameter SpA of the photosensitive resin composition is preferably 10.0 or more and 14.0 or less. Therefore, from the viewpoint of increasing the absolute value of the difference between the solubility parameters of the photosensitive resin composition and the negative film and suppressing elution and migration of the negative film to the photosensitive resin composition, when the solubility parameter SpB of the negative film is more than the SpA, SpB is preferably 13.0 or more, more preferably 13.5 or more, still more preferably 14.0 or more, and even more preferably more than 14.0.

When the SpB is more than the SpA, the material of the negative film is not limited to the following, but preferred examples thereof include at least one selected from the group consisting of polyurethane, polylactic acid, polycarbonate, polyester, polyamide, polybutyral, polyvinyl alcohol, poly(meth)acrylate, and modified products or partially saponified products thereof. In particular, polyurethane and/or polybutyral is preferable.

When the SpB is more than the SpA, the material constituting a blackened layer as the negative film tends to have higher polarity, and since the strength of the blackened layer and the adhesion with a hard plate in contact with the negative film are improved, the blackened layer tends to have superior scratch resistance and solvent resistance.

By setting the solubility parameter SpB of the negative film to 13.0 or more, since the solubility parameter SpA of the photosensitive resin composition can usually be specified by materials that are used as photosensitive resin compositions for producing flexographic printing plates, the absolute value of the difference between SpA and SpB can be controlled to be 2.0 or more. As a result, elution and migration of the negative film to the photosensitive resin composition layer can be suppressed.

On the other hand, when the solubility parameter SpB of the negative film is less than the SpA, SpB is preferably less than 10.0, more preferably 9.5 or less, and still more preferably 9.0 or less.

When the SpB is smaller than the SpA, the material of the negative film is not limited to the following, but preferred examples thereof include those conventionally used in the production of flexographic printing plates, such as thermoplastic elastomer block copolymers, completely or partially hydrolyzed polyvinyl esters, partially hydrolyzed polyvinyl acetate, polyvinyl alcohol derivatives, partially hydrolyzed vinyl acetate/alkylene oxide graft copolymers or polyvinyl alcohol subsequently acrylated by a polymer-analogous reaction, polybutadiene, polyamide, and mixtures thereof.

Examples of the thermoplastic elastomer block copolymers include those containing at least one block containing an alkenyl aromatic monomer unit and at least one block containing a 1,3-diene monomer unit.

Examples of the alkenyl aromatic compound that forms the alkenyl aromatic monomer unit include styrene, α-methylstyrene, and vinyltoluene. As 1,3-diene, for example, butadiene and isoprene are preferable from the viewpoint of reducing the steric hindrance of a vinyl group, enhancing photo-crosslinking efficiency, and preventing elution of the ablation layer to the original printing plate after exposure.

The solubility parameter SpB of the negative film can be controlled within the above-described numerical range by appropriately selecting a resin material constituting the negative film. Specifically, it can be controlled to be high by selecting a resin material having high polarity, and can be controlled to be low by selecting a resin material having low polarity.

By setting the solubility parameter SpB of the negative film to 9.0 or less, since the solubility parameter SpA of the photosensitive resin composition can usually be specified by materials that are used as photosensitive resin compositions for producing flexographic printing plates, the absolute value of the difference between SpA and SpB can be controlled to be 2.0 or more. As a result, elution and migration of the negative film to the photosensitive resin composition layer can be suppressed.

### <Negative Film According to First Form>

In the method for producing a printing plate according to the present embodiment, as the negative film, it is possible to use one having a configuration having a base material and an ablation layer stacked on the base material (hereinafter, the negative film in this form may be referred to as negative film according to the first form).

Note that, in the negative film according to the first form, the solubility parameter SpB of the negative film means the solubility parameter of the ablation layer.

The negative film according to the first form preferably contains a resin having a constituent unit represented by the following general formula (II). More specifically, it is preferable that the negative film has a base material and an ablation layer stacked on the base material, and that the ablation layer contains a resin having a constituent unit represented by the following general formula (II).

Note that the negative film used in the method for producing a printing plate according to the present embodiment is not limited to the negative film according to the first form.

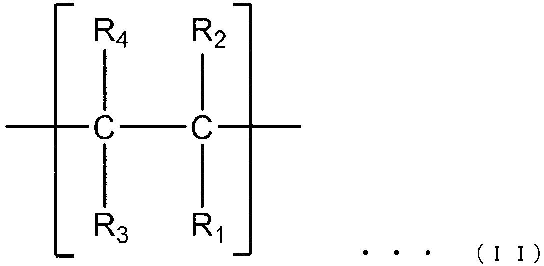

In the formula (II), R₁ and R₂ each independently represent a non-polar group, and R₃ and R₄ each independently represent a hydrogen atom or a non-polar group.

Figure 2 shows a schematic cross-sectional view of an example of a negative film used in the method for producing a printing plate according to the present embodiment.

In the negative film shown in Figure 2, a base material 21 and an ablation layer 22, which functions as a mask when forming the target concavo-convex pattern and microcell pattern of a printing plate, are stacked.

Hereinafter, the negative film will be described in detail.

### [Base Material]

The negative film shown in Figure 2 has the base material 21 and the ablation layer 22 stacked on the base material 21. The ablation layer 22 is image-drawn and thus serves as a negative film for forming a relief and microcells in the production step of a printing plate, which will be described later.

The quality, especially image reproducibility, of the relief and microcells is greatly affected by the negative film through which ultraviolet light transmits during the exposure. In general, the larger the thickness of the negative film, the greater the refraction and scattering of ultraviolet light in the negative film, and the lower the image reproducibility tends to be. Since the thickness of the base material 21 shown in Figure 2 accounts for the majority of the overall thickness of the negative film, a smaller thickness of the base material 21 is preferable from the viewpoint of printing plate quality.

On the other hand, it is also important for the negative film to have a certain degree of rigidity and dimensional stability. If the negative film is easily deformed, it tends to induce deformation and damage to the image formed on the negative film in the step before the relief exposure, resulting in reduced image reproducibility. However, if the rigidity of the negative film is too high, it tends to cause incompatibility with the apparatus in the production step of the target printing plate, or excessive stress concentration on the ablation layer during handling, causing irreversible damage such as scratches and wrinkles.

From the above-described viewpoints, the base material 21 preferably has a thickness of 10 µm or more and less than 100 µm The above numerical value range gives a negative film with excellent image reproducibility and moderate rigidity. Furthermore, the thickness is preferably 20 µm or more, and more preferably 40 µm or more. When the base material 21 has a thickness of 10 µm or more, sufficient strength and rigidity for practical use can be obtained, and deformation and damage to the image can be suppressed during the production step of a printing plate. In addition, from the viewpoint of ensuring moderate flexibility and providing good handleability in the production step of a printing plate, the thickness of the base material 21 is preferably less than 100 µm, more preferably 90 µm or less, and still more preferably 70 µm or less.

The base material 21 preferably contains a resin having a polyester or polyolefin skeleton from the viewpoints of dimensional stability, transparency, and adhesion with the ablation layer 22. Here, the resin contained in the base material 21 may be a mixture of resins having polyester and polyolefin skeletons, or it may be a copolymer.

Examples of the polyester include, but are not limited to, polyethylene terephthalate, polybutylene terephthalate, and polyethylene naphthalate.

Examples of the resin having a polyolefin skeleton include, but are not limited to, polyethylene, polypropylene, and a resin in which they are copolymerized.

In addition, from the viewpoint of image reproducibility, the base material 21 is more preferably made of a resin having a polyester or polyolefin skeleton, and further preferably made of a resin having a polyolefin skeleton. This is because the resin having a polyolefin skeleton has a high oxygen permeability. Here, the oxygen permeability is one of the physical property values of the film, and represents the amount of oxygen that passes through per 1 m² of film in one day under the condition of 1 atm (1 atmospheric pressure). The unit is cm³/m²·24 h·atm, where a larger value indicates easier passage and a smaller value indicates harder passage.

In the production step of a printing plate, when the photosensitive resin composition layer is cured by ultraviolet ray irradiation, the curing of the photosensitive resin composition proceeds by radical polymerization. If oxygen coexists during this radical polymerization, the polymerization reaction is inhibited by the reaction between the radical-producing compound and oxygen. That is, by reducing the amount of oxygen coexisting during exposure of the photosensitive resin composition layer, the degree of polymerization can be increased, and the image reproducibility of the final flexographic printing plate can be enhanced. Here, if the base material 21 of the negative film stacked on the photosensitive resin composition layer has a high oxygen permeability, the oxygen remaining on the surface and/or inside of the photosensitive resin composition layer during ultraviolet ray irradiation can easily diffuse to the outside, and the effect of inhibition of polymerization reaction by oxygen can be suppressed.

In the negative film, the base material 21 may be used in an untreated state. However, it may be subjected to a predetermined surface treatment as necessary, or one that has been given a function such as antistatic treatment may be used. Examples of the surface treatment include a corona treatment and a matte processing.

### [Ablation Layer]

In the negative film shown in Figure 2, the ablation layer 22 is stacked on top of the base material 21.

The ablation layer 22 contains a predetermined resin, is ablatable by an infrared laser, and also has the function as a shielding layer for rays other than infrared ray.

In order to suppress elution of components contained in the ablation layer 22 to the photosensitive resin composition layer and migration of the ablation layer 2 to the photosensitive resin composition, it is effective to improve the adhesion between the base material 21 and the ablation layer 22 or to decrease the miscibility of the ablation layer 22 with the photosensitive resin composition layer. In particular, in the present embodiment, the absolute value of the difference between the solubility parameter SpA of the photosensitive resin composition and the solubility parameter of the negative film, that is, the solubility parameter SpB of the ablation layer constituting the negative film, is specified to be 2.0 or more. As a result, even when the ablation layer of the negative film is directly stacked with the photosensitive resin composition, elution and migration of the ablation layer to the photosensitive resin composition layer can be effectively suppressed.

The ablation layer 22 contains a resin, an infrared ray absorbing substance, a shielding substance for non-infrared ray such as ultraviolet ray, and others.

From the viewpoint of improving the adhesion between the base material 21 and the ablation layer 22, it is important to strengthen the interaction between the layers. Examples of such a method for strengthening the interaction between the layers include a method in which the chemical interaction is improved and a method in which the physical interaction is improved.

Examples of the method in which the chemical interaction is improved include a method in which similar molecular structures are given to the constituent materials of both the base material 21 and the ablation layer 22. Examples of the method for improving the physical interaction include a method in which the flexibility of the ablation layer 22 is improved or moderate flexibility is given in order to suppress peeling at the time of film bending. In addition, a method is also effective in which similar molecular structures are given to the constituent materials of both the base material 21 and the ablation layer 22 in order to improve chemical interaction, thereby maintaining interlayer adhesion, while ensuring high ablation efficiency of the ablation layer 22 with an infrared laser.

Furthermore, from the viewpoint of decreasing the miscibility between the ablation layer 22 and the photosensitive resin composition layer, it is effective to select an appropriate one as the resin material in the ablation layer 22.

From the above-described viewpoints, in the negative film used in the method for producing a printing plate according to the present embodiment, it is preferable that the ablation layer 22 contains a resin having a constituent unit represented by the following general formula (II), which contains a quaternary carbon atom to which two non-polar groups are bonded.

The resin may have other constituent units as necessary.

In the present specification, "monomer" means a compound before polymerization, and "constituent unit" means a predetermined repeating unit constituted by the polymerization of a monomer.

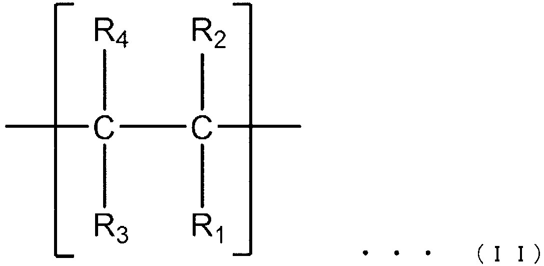

In the formula (II), R₁ and R₂ each independently represent a non-polar group, and R₃ and R₄ each independently represent a hydrogen atom or a non-polar group.

As described above, it is preferable that the ablation layer 22 in the negative film used in the method for producing a printing plate according to the present embodiment contains a resin having a constituent unit represented by the general formula (II).

In the case where the resin contained in the ablation layer 22 has polar groups in the main chain, the strength of the ablation layer 22 is improved due to the strong formation of non-covalent bonds between molecules. Meanwhile, the structure used to interact with the constituent starting materials of the base material 21 is reduced, and the adhesion between the base material 21 and the ablation layer 22 tends to decrease. In addition, the rigidity of the ablation layer 22 tends to become too high, and the stress caused by bending and stretching tends to concentrate between the layers, which can easily lead to interfacial peeling.

Furthermore, in the case where the resin contained in the ablation layer 22 has polar groups in side chains, it tends to be not preferable from the viewpoint of ablation efficiency of the ablation layer 22 with a laser, as will be described below.

To ensure ablation efficiency with a laser, it is important that the resin contained in the ablation layer 22 is easily depolymerized. "Depolymerization" refers to the reverse reaction of the polymerization reaction, in which the polymer is decomposed into monomers.

The irradiation with an infrared laser causes the ablation layer 22 to instantaneously reach a high temperature of several hundred degrees Celsius. At that time, decomposition of the main chains in the resin occurs, resulting in a rapid drop in molecular weight, which is removed from the ablation layer 22. However, in the case of a resin that is not easily depolymerized, only degradation of side chains tends to occur during ablation, and no cleavage of the main chain tends to occur. Therefore, the resin remains in the ablation layer 22 even after the irradiation with an infrared laser. Resins obtained by condensation polymerization are known to form a ring structure at the time of decomposition, followed by cleavage of the main chain. That is, a drop in molecular weight does not occur easily with infrared ray ablation, which is a heat treatment for a short time, and an ablation layer containing a resin obtained by such condensation polymerization tends to have poor ablation efficiency.

From the above-described viewpoints, it is important that the ablation layer 22 contains a resin that is easily depolymerized. In general, it is known that cleavage of the main chain is likely to start from thermally unstable portions present in the polymer such as branches. However, if side chains corresponding to branches have polarity at this time, decomposition of the side chains is likely to occur dominantly, which is not preferable because it is difficult for cleavage of the main chain to occur.

Therefore, it is preferable that side chains of the resin contained in the ablation layer 22 are non-polar groups. Also, when cleavage of the main chain proceeds, the contribution of intramolecular or intermolecular chain transfer cannot be neglected. Therefore, it is preferable to have no tertiary hydrogen, which is easily abstracted by chain transfer. In other words, it is preferable that the portion corresponding to the symmetry plane of the branch is also a non-polar group.

It is also important that the side chains are non-polar groups from the viewpoint of acquiring rubber-like elasticity. This provides a soft part in the elastomer and improves the flexibility of the ablation layer 22.

From the above-described viewpoints, in the negative film, the content of the resin having a constituent unit represented by the general formula (II) in the ablation layer is preferably 20% by mass or more, more preferably 30% by mass or more, and further preferably 40% by mass or more.

The non-polar groups in the above general formula (II) are preferably any of the following: an alkyl group, an aryl group, a cycloalkyl group, a phenyl group, an alkenyl group, an aralkyl group, a cycloalkenyl group, an alkynyl group, a silyl group, and a siloxanyl group. The non-polar groups do not include a hydrogen atom.

In particular, from the viewpoint of improving the flexibility of the ablation layer 22 and ensuring the adhesion with the base material 21, in the general formula (II), it is more preferable that R₁ and R₂ are each independently any one selected from the group consisting of an alkyl group, an alkenyl group, and an alkynyl group, and in terms of having low polarity, it is further preferable that they are alkyl groups.

Examples of the monomer capable of forming a constituent unit represented by the general formula (II) include, but are not limited to, isobutylene, 2-methyl-2-butene, 2,3-dimethyl-2-butene, and those in which a methyl group of these is replaced by another alkyl group such as ethyl group, and modified products thereof; α-methylstyrene, cis-(1-methyl-1-propenyl)benzene, trans-(1-methyl-1-propenyl)benzene, and those in which a methyl group of these is replaced by another alkyl group such as ethyl group, and their modified products; and 1,1-diphenylethylene.

In the general formula (II), R₃ and R₄ each independently represent a hydrogen atom or a non-polar group.

It is preferable that R₃ and R₄ are each independently any one selected from the group consisting of a hydrogen atom, an alkyl group, an alkenyl group, and an alkynyl group, and it is more preferable that they are each independently a hydrogen atom or an alkyl group. It is further preferable that R₃ and R₄ are both hydrogen atoms, as the depolymerizability of the resin is further improved.

The constituent unit represented by the general formula (II) constituting the resin may be of one type alone or of two or more types. For example, the resin may have, as the constituent unit (II), a constituent unit in which R₁ and R₂ are alkyl groups, and a constituent unit in which one of R₁ and R₂ is an alkyl group and the other is a phenyl group. By having both an alkyl group and a phenyl group, the characteristics of the both groups can be obtained.

It is preferable that the above-described resin contained in the ablation layer 22 further contain, in addition to the constituent unit represented by the general formula (II), a constituent unit derived from a monovinyl-substituted aromatic hydrocarbon.

The monovinyl aromatic hydrocarbon may be chemically bonded to the constituent unit represented by the general formula (II), or may be added as a separate resin, but from the viewpoints of dispersibility and resulting laser processing uniformity, it is preferable that the constituent unit derived from the monovinyl-substituted aromatic hydrocarbon is chemically bonded to the constituent unit represented by the general formula (II), forming a copolymer.

When the resin used for the ablation layer contains a constituent unit derived from a monovinyl-substituted aromatic hydrocarbon, the adhesion between the ablation layer 22 and the base material 21 tends to be improved and the rigidity of the negative film also tends to be improved.

Examples of the compound used for forming the constituent unit derived from the monovinyl aromatic hydrocarbon include, but are not limited to, monomers such as styrene, t-butylstyrene, N,N-dimethyl-p-aminoethylstyrene, N,N-diethyl-p-aminoethylstyrene, vinylpyridine, p-methylstyrene, and tert-butylstyrene. In particular, styrene is preferable from the viewpoint of being able to smoothly mold the negative film at a relatively low temperature.

The constituent unit derived from a monovinyl-substituted aromatic hydrocarbon may be of only one type alone or of two or more types.

The ablation layer 22 may contain an infrared ray absorbing substance to perform ablation processing.

Examples of the infrared ray absorbing substance include a simple substance or compound that has strong absorption, usually in the range of 750 to 2000 nm.

Examples of the infrared ray absorbing substance include, but are not limited to, an inorganic pigment such as carbon black, graphite, copper chromite, and chromium oxide; and a dye such as polyphthalocyanine compound, cyanine dye, and metal thiolate dye. The smaller the particle size, the higher the sensitivity to the infrared laser. In particular, carbon black can be used with a particle size in the wide range of 13 to 85 nm, and is preferable as the infrared ray absorbing substance. Carbon black can also function as the shielding substance, as will be described below. These infrared ray absorbing substances are added to the extent that they provide sensitivity capable of being ablated by the laser beam used.

The ablation layer 22 may contain a shielding substance for non-infrared rays such as ultraviolet ray in order to serve as a mask. As the shielding substance for non-infrared rays, a substance that reflects or absorbs ultraviolet light can be used.

Examples of the shielding substance include, but are not limited to, an ultraviolet ray absorber, carbon black, and graphite.

The ablation layer 22 should have a larger film thickness from the viewpoint of ensuring shielding against an ultraviolet ray during the exposure step described below, and should have a thinner film thickness from the viewpoint of increasing ablatability.

From the above viewpoints, the film thickness of the ablation layer 22 is preferably 0.1 µm or more and 20 µm or less, more preferably 0.5 µm or more and 15 µm or less, and further preferably 1.0 µm or more and 10 µm or less.

For the non-infrared ray shielding effect of the ablation layer 22, the ablation layer 22 preferably has an optical density of 2 or more, and more preferably has an optical density of 3 or more.

The optical density can be measured using the D200-II transmission densitometer (manufactured by GretagMacbeth LLC). In addition, the optical density is the so-called visual density (ISO visual), and the light to be measured is in the wavelength range of about 400 to 750 nm.

### <Method for Producing Negative Film According to First Form>

Examples of the method for producing the above-described negative film according to the first form include, but are not limited to, the following method: for example, in the case of using carbon black as both the infrared ray absorbing substance and the shielding substance for non-infrared ray, at first, a solution of the resin having a constituent unit represented by the general formula (II) described above is prepared using a predetermined solvent, carbon black and a dispersing agent are added thereto, and carbon black is dispersed in the resin solution to thereby obtain a solution or dispersion for ablation layer 22 film formation. Thereafter, a predetermined base material 21 is coated with the solution or dispersion for ablation layer film formation to thereby producing a negative film.

As the method for dispersing carbon black in the resin solution, a method of using forced stirring with a stirring blade in combination with stirring utilizing ultrasonic waves or various types of mills is effective. Alternatively, the resin, carbon black, and the dispersing agent are preliminary kneaded using an extruder or kneader and then dissolved in the solvent, which is also an effective method for obtaining good dispersibility of carbon black. Another example is a method in which carbon black is forcibly dispersed in the resin in the state of a latex dispersion.

The solvent used to prepare the solution or dispersion for ablation layer 22 film formation can be selected as appropriate, taking into consideration the solubility of the resin and infrared ray absorber to be used. Only one type of solvent may be used, or a mixture of two or more solvents may be used.

Also, the film quality of the ablation layer 22 can be improved by mixing a solvent with a relatively low boiling point and a solvent with a high boiling point to control the volatilization rate of the solvent, for example.

Examples of the solvent for ablation layer 22 film formation include, but are not limited to, toluene, xylene, cyclohexane, methyl acetate, ethyl acetate, propyl acetate, butyl acetate, amyl acetate, methyl ethyl ketone, acetone, cyclohexanone, ethylene glycol, propylene glycol, ethanol, water, propylene glycol monomethyl ether, propylene glycol monomethyl ether acetate, dimethylacetamide, dimethylformamide, n-propyl alcohol, i-propyl alcohol, 1,4-dioxane, tetrahydrofuran, diethyl ether, n-hexane, n-heptane, n-pentane, acetonitrile, and analogues thereof.

### <Negative Film According to Second Form>

In the method for producing a printing plate according to the present embodiment, as the negative film, it is possible to use one having a configuration having a UV printing polymer layer with a desired pattern on a predetermined UV printing base material.

### [UV Printing Base Material]

As the UV printing base material, although not limited to the following, it is possible to use one including a transparent material selected from the group consisting of polyethylene terephthalate, polycarbonate, and polyethylene naphthalate.

The UV printing base material preferably has a thickness of 10 µm or more and less than 100 µm. The above numerical value range gives a negative film with excellent image reproducibility and moderate rigidity. Furthermore, the thickness is preferably 20 µm or more, and more preferably 40 µm or more. When the UV printing base material has a thickness of 10 µm or more, sufficient strength and rigidity for practical use can be obtained, and deformation and damage to the image can be suppressed during the production step of a printing plate. In addition, from the viewpoint of ensuring moderate flexibility and providing good handleability in the production step of a printing plate, the thickness of the UV printing base material is preferably less than 100 µm, more preferably 90 µm or less, and still more preferably 70 µm or less.

### [UV Printing Polymer Layer]

As the UV ink, one containing one or more photoinitiators, monomers, binders, and dye materials can be used, and examples of the dye materials include those including a four-color system including cyan, magenta, yellow, and black. The UV ink is preferably one that is cured by exposure to at least one UV light source with a wavelength output in the range of about 365 nm to about 405 nm.

Such a UV printing polymer layer has a predetermined pattern in the negative film, and after the above-described exposure curing, contains a polymer that is a polymer of the monomers.

As the polymer, although not limited to the following, examples thereof include at least one selected from the group consisting of polyurethane, polylactic acid, polycarbonate, polyester, polyamide, polybutyral, polyvinyl alcohol, poly(meth)acrylate, and modified products or partially saponified products thereof.

In order to suppress elution of components contained in the UV printing polymer layer to the photosensitive resin composition layer and migration of the UV printing polymer layer to the photosensitive resin composition, it is effective to improve the adhesion between the UV printing base material and the UV printing polymer layer or to decrease the miscibility of the UV printing polymer layer with the photosensitive resin composition layer. In particular, in the present embodiment, the absolute value of the difference between the solubility parameter SpA of the photosensitive resin composition and the solubility parameter SpB of the negative film, that is, the UV printing polymer layer, is specified to be 2.0 or more. As a result, even when directly stacked with the photosensitive resin composition, elution and migration of the UV printing polymer layer to the photosensitive resin composition layer can be effectively suppressed.

### <Method for Producing Negative Film According to Second Form>

The negative film according to the second form is obtained by dispersing UV ink on the UV printing base material in a desired pattern using, for example, an ink jet printer, curing the UV ink with a chemical radiation source to crosslink and cure the UV ink, and forming a UV printing polymer layer in the desired pattern.

### <Photosensitive Resin Composition Layer>

In the method for producing a printing plate according to the present embodiment, a liquid photosensitive resin composition layer is directly stacked on the above-described negative film.

The liquid photosensitive resin composition has high fluidity and can easily change its shape. For this reason, when stacked on the negative film, the liquid photosensitive resin composition is brought into a state molded into a film with a constant thickness inside a dedicated apparatus (plate maker).

For example, as shown in Figure 1, the negative film 1 is placed on the ultraviolet transmitting first hard plate 11, the liquid photosensitive resin composition is poured thereon, to which the support 3 is laminated so as to attain a constant plate thickness, and furthermore, the negative film for back exposure 4 and the second hard plate 12 are pressed thereagainst to form the photosensitive resin composition layer 2.

In this step of forming the photosensitive resin composition layer 2, after placing the negative film 1 on the first hard plate 11, it is preferable to vacuum the negative film 1 for the purposes of securely fixing the negative film 1 and removing oxygen-inhibiting factors. Examples of the mechanism for vacuuming include, but are not limited to, a method in which vacuuming is performed with a pump through a groove established around the first hard plate 11.

If the rigidity of the negative film 1 is insufficient, the negative film 1 wrinkles in the vacuuming step, and in severe cases, wrinkles cannot be removed and remain. The resulting wrinkles are transferred to the relief surface after curing and may significantly reduce image reproducibility. In addition, if the dimensional stability of the negative film 1 is insufficient, the pattern drawn and processed is deformed, which is likewise a contributing factor to reduced image reproducibility.

On the other hand, in the case where the rigidity of the negative film 1 is too high, the film cannot follow the lower glass completely at the time of vacuuming, leaving a gap and remaining air. As a result, the effect of oxygen inhibition may be increased, which may adversely affect image reproducibility. In addition, the stress caused by deformation of the highly elastic negative film 1 may be concentrated in the ablation layer, resulting in wrinkles and pinholes. That is, it is extremely important that the negative film 1 has rigidity in the appropriate range.

The photosensitive resin composition layer preferably contains, for example, the polymer (b-1), ethylenically unsaturated compound (b-2), and photopolymerization initiator (b-3) described later. They can be used selectively as appropriate.

The photosensitive resin composition layer may further contain an auxiliary additive component, if necessary.

The solubility parameter SpA of the photosensitive resin composition constituting the photosensitive resin composition layer is usually specified by materials that are used as photosensitive resin compositions for producing flexographic printing plates. From a practical viewpoint, the solubility parameter SpA of the photosensitive resin composition is 10.0 or more and 14.0 or less.

Hereinafter, each component of the photosensitive resin composition layer will be described in detail.

### [Polymer (b-1)]

The polymer (b-1) may be a linear, branched, or dendritic polymer, and may be a homopolymer or a copolymer. The copolymer may be a random copolymer, an alternating copolymer, or a block copolymer.

Examples of the polymer (b-1) include a polymer conventionally used in the production of flexographic printing plates, such as completely or partially hydrolyzed polyvinyl ester, partially hydrolyzed polyvinyl acetate, a polyvinyl alcohol derivative, a partially hydrolyzed vinyl acetate/alkylene oxide graft copolymer, or polyvinyl alcohol subsequently acylated polymer-analogous reaction, polybutadiene, polyamide, and mixtures thereof.

In addition to those described above, a thermoplastic elastomer block copolymer can also be used, for example.

Examples of the thermoplastic elastomer block copolymer include a copolymer containing at least one block containing an alkenyl aromatic monomer unit and at least one block containing a 1,3-diene monomer unit. Examples of the alkenyl aromatic compound that forms the alkenyl aromatic monomer unit include styrene, α-methylstyrene, and vinyltoluene. As 1,3-diene, for example, butadiene and isoprene are preferable from the viewpoint of reducing the steric hindrance of a vinyl group, enhancing photo-cross-linking efficiency, and preventing elution of the ablation layer to the original printing plate after exposure.

Furthermore, the polymer (b-1) preferably includes a compound having a carbonyl group. The use of a compound having a carbonyl group with high polarity as the polymer (b-1) tends to be able to decrease the miscibility with the resin having non-polar groups in the ablation layer, so that elution of the ablation layer to the photosensitive resin composition layer can be suppressed.

Examples of the polymer (b-1) include, but are not limited to, polyester, polyamide, and polyurethane. From the viewpoint of preventing damage to the relief surface due to the load when peeling off the film for flexographic printing plate production after the exposure step, the polymer (b-1) more preferably includes polyurethane. The polyurethane preferably has a (meth)acrylic group as a terminal group from the viewpoint of improving the mechanical physical properties of the finally obtained flexographic printing plate by photo-cross-linking.

The photosensitive resin composition layer used in the method for producing a printing plate according to the present embodiment preferably has a solubility parameter SpA controlled to be 10.0 or more and 14.0 or less from a practical viewpoint, and preferably contains 60% by mass or more of polyurethane from the viewpoint of suppressing elution of the ablation layer to the photosensitive resin composition layer. Note that, in such a configuration, the negative film preferably contains 20% by mass or more and less than 60% by mass of polyurethane and/or polybutyral. As a result, elution of the ablation layer to the photosensitive resin composition layer can be effectively suppressed.

Examples of a method for producing the polyurethane having a (meth)acrylic group as a terminal group include a method of reacting diol having a repeat unit in the molecule with diisocyanate to form polyurethane having a terminal isocyanate group with an arbitrary molecular weight, and subsequently reacting the polyurethane with a compound having active hydrogen and a (meth)acrylic group in one molecule for production. Another example thereof includes a method of reacting diol having a repeat unit in the molecule with diisocyanate to form polyurethane having a terminal isocyanate group with an arbitrary molecular weight, and subsequently reacting the polyurethane with a compound having a hydroxy group and a (meth)acrylic group in one molecule for production.

The polyurethane structure obtained by the production method described above is a structure constructed through the reaction of diol having a repeat unit in the molecule with diisocyanate.

Hereinafter, the "polyurethane having a (meth)acrylic group as a terminal group" produced by the method described above is referred to as an "unsaturated prepolymer".

Examples of the "diol having a repeat unit in the molecule" for use in the production of the unsaturated prepolymer include, but are not limited to, polyester diol consisting of dicarboxylic acid and diol; polyether diol; polyether/polyester copolymer diol; and a 1,2-polybutadiene compound having a terminal hydroxy group. The diol having a repeat unit in the molecule may be used singly or may be used in combinations of two or more thereof.

Examples of the dicarboxylic acid constituting the polyester diol include, but are not limited to, succinic acid, glutaric acid, adipic acid, pimelic acid, suberic acid, azelaic acid, sebacic acid, maleic acid, terephthalic acid, isophthalic acid and 1,5-naphthalenedicarboxylic acid.

Examples of the diol constituting the polyester diol include, but are not limited to, 1,4-butanediol, 2-methyl-1,3-propanediol, 3-methyl-1,5-pentanediol, neopentyldiol, 1,6-hexanediol, 1,9-nonanediol, 2-methyl-1,8-octanediol, and diethylene glycol (dioxyethylenediol).

Examples of the polyether diol include, but are not limited to, polyoxyethylenediol, polyoxypropylenediol, polyoxytetramethylenediol, polyoxy 1,2-butylenediol, polyoxyethylene/polyoxypropylene random copolymer diol, polyoxyethylene/polyoxypropylene block copolymer diol, polyoxyethylene/polyoxytetramethylene random copolymer diol, and polyoxyethylene/polyoxytetramethylene block copolymer diol.

Examples of the polyether/polyester copolymer diol include, but are not limited to, a copolymer having a structure where the repeat unit that forms the molecular chain of the above-described polyether diol and the repeat unit that forms the molecular chain of the above-described polyester diol are linked in a block or random pattern.

The 1,2-polybutadiene compound having a terminal hydroxy group may be a hydrogenated compound. Examples of the 1,2-polybutadiene compound having a terminal hydroxy group include, but are not limited to, poly-1-butene hydride and 1,2-polybutadiene hydride. The number of terminal hydroxy groups is not particularly limited and is preferably 1.2 or more, more preferably 1.5 or more, and further preferably 2.0 or less per molecule from the viewpoint of preventing damage to the relief surface due to the load when peeling off the film for printing plate production after exposure.

Examples of the diisocyanate include, but are not limited to, tolylene diisocyanate, xylylene diisocyanate, hexamethylene diisocyanate, trimethylhexamethylene diisocyanate, isophorone diisocyanate, diphenylmethane diisocyanate, cyclohexane diisocyanate, dicyclohexylmethane diisocyanate, and norbornene diisocyanate.

The diisocyanate may be used singly or in combinations of two or more thereof.

### [Ethylenically Unsaturated Compound (b-2)]

The photosensitive resin composition layer preferably contains an ethylenically unsaturated compound (b-2), as described above. The ethylenically unsaturated compound (b-2) is a compound having a radically polymerizable unsaturated double bond. Examples of the ethylenically unsaturated compound (b-2) include, but are not limited to, olefins such as ethylene, propylene, vinyltoluene, styrene, and divinylbenzene; acetylenes; (meth)acrylic acid and/or derivatives thereof; haloolefins; unsaturated nitriles such as acrylonitrile; unsaturated amides such as acrylamide or methacrylamide, and derivatives thereof; unsaturated dicarboxylic acids and derivatives thereof such as maleic anhydride, maleic acid, and fumaric acid; vinyl acetates; N-vinylpyrrolidone; N-vinylcarbazole; and N-substituted maleimide compounds.

Examples of each of the derivatives include, but are not limited to, an alicyclic compound having a cycloalkyl group, a bicycloalkyl group, a cycloalkenyl group, a bicycloalkenyl group, or the like; an aromatic compound having a benzyl group, a phenyl group, a phenoxy group, a naphthalene skeleton, an anthracene skeleton, a biphenyl skeleton, a phenanthrene skeleton, a fluorene skeleton, or the like; a compound having an alkyl group, a halogenated alkyl group, an alkoxyalkyl group, a hydroxyalkyl group, an aminoalkyl group, a glycidyl group, or the like; an ester compound with a polyhydric alcohol such as an alkylene glycol, a polyoxyalkylene glycol, a polyalkylene glycol, or trimethylolpropane; and a compound having a polysiloxane structure, such as polydimethylsiloxane and polydiethylsiloxane.

In addition, the ethylenically unsaturated compound (b-2) may be a heteroaromatic compound containing an element such as nitrogen or sulfur.

Examples of the (meth)acrylic acid and/or derivatives thereof include, but are not limited to, a diacrylate and a dimethacrylate of an alkanediol such as hexanediol or nonanediol; a diacrylate and a dimethacrylate of ethylene glycol, diethylene glycol, propylene glycol, dipropylene glycol, polyethylene glycol, or butylene glycol; trimethylolpropane tri(meth)acrylate; dimethylol tricyclodecane di(meth)acrylate; isobornyl (meth)acylate; phenoxy polyethylene glycol (meth)acrylate; and pentaerythrit tetra(meth)acrylate.

These may be used singly or in combinations of two or more thereof.

From the viewpoint of preventing damage to the relief surface due to the load when peeling off the negative film after exposure, at least one (meth)acrylate is preferably used, and at least one bifunctional (meth)acrylate is more preferably used as the ethylenically unsaturated compound (b-2).

### [Photopolymerization Initiator (b-3)]

The photosensitive resin composition layer preferably contains a photopolymerization initiator (b-3).

The photopolymerization initiator (b-3) is a compound that absorbs the energy of light to produce a radical. Examples thereof include a degradable photopolymerization initiator, a hydrogen abstraction type photopolymerization initiator, and a compound having a site functioning as a hydrogen abstraction type photopolymerization initiator and a site functioning as a degradable photopolymerization initiator in the same molecule.

Examples of such a photopolymerization initiator (b-3) include, but are not limited to, benzophenones such as benzophenone, 4,4-bis(diethylamino)benzophenone, 3,3',4,4'-benzophenone tetracarboxylic anhydride, and 3,3',4,4'-tetramethoxy benzophenone; anthraquinones such as t-butyl anthraquinone and 2-ethyl anthraquinone; thioxanthones such as 2,4-diethyl thioxanthone, isopropyl thioxanthone, and 2,4-dichloro thioxanthone; Michler's ketone; acetophenones such as diethoxyacetophenone, 2,2-dimethoxy-2-phenylacetophenone, 2-hydroxy-2-methyl-1-phenylpropan-1-one, benzyl dimethyl ketal, 1-hydroxycyclohexyl-phenyl ketone, 2-methyl-2-morpholino(4-thiomethylphenyl)propan-1-one, 2-methyl-1-(4-methylthiophenyl)-2-morpholino-propan-1-one, 2-benzyl-2-dimethylamino-1-(4-morpholinophenyl)-butanone, and trichloroacetophenone; benzoin ethers such as benzoin methyl ether, benzoin ethyl ether, benzoin isopropyl ether, and benzoin isobutyl ether; acylphosphine oxides such as 2,4,6-trimethylbenzoyl diphenyl phosphine oxide, bis(2,6-dimethoxybenzoyl)-2,4,4-trimethyl pentyl phosphine oxide, and bis(2,4,6-trimethylbenzoyl)-phenyl phosphine oxide; methyl benzoylformate; 1,7-bisacridinyl heptane; 9-phenyl acridine; and azo compounds such as azobisisobutyronitrile, diazonium compounds, and tetrazene compounds.

These may be used singly or in combinations of two or more thereof.

The content of the photopolymerization initiator (b-3) in the photosensitive resin composition layer is preferably 0.1% by mass or more and 10% by mass or less, more preferably 0.1% by mass or more and 5% by mass or less, and further preferably 0.3% by mass or more and 5% by mass or less when the whole amount of the photosensitive resin composition layer is assumed to be 100% by mass from the viewpoint of preventing damage to the relief surface due to the load when peeling off the negative film after exposure.

### [Auxiliary Additive Component]

The auxiliary additive component is not limited, and examples thereof include a plasticizer, a thermal polymerization inhibitor, an antioxidant, a light stabilizer, an ultraviolet ray absorber, and a dye or pigment.

Examples of the plasticizer include, but are not limited to, a liquid diene such as liquid polybutadiene, liquid polyisoprene, a modified product of liquid polybutadiene, a modified product of liquid polyisoprene, a liquid acrylonitrile-butadiene copolymer, and a liquid styrene-butadiene copolymer; a hydrocarbon oil such as naphthene oil and paraffin oil; a conjugated diene rubber mainly composed of a liquid diene, such as a liquid acrylonitrile-butadiene copolymer or a liquid styrene-butadiene copolymer; a polystyrene having a number average molecular weight of 2000 or less; and an ester-based plasticizer such as a sebacic acid ester or a phthalic acid ester.

These plasticizers may have a hydroxyl group or a carboxyl group. In addition, a photopolymerizable, reactive group such as a (meth)acryloyl group may be added thereto.

The plasticizers may be used singly, or two or more thereof may be used together.

In the present specification, "liquid" means a characteristic having the property of being easily flow-deformable and capable of being solidified into a deformed shape by cooling.

The content of the plasticizer in the photosensitive resin composition layer is preferably 0% by mass or more and 30% by mass or less, more preferably 8% by mass or more and 30% by mass or less, and further preferably 8% by mass or more and 25% by mass or less when the whole amount of the photosensitive resin composition layer is assumed to be 100% by mass from the viewpoint of preventing damage to the ablation layer when peeling off the negative film after exposure and elution to the photosensitive resin composition layer.

As the thermal polymerization inhibitor and the antioxidant, those usually used in the field of resin materials or rubber materials can be used. Specific examples thereof include a phenol-based material.

Examples of the phenol-based material as the thermal polymerization inhibitor and the antioxidant include, but are not limited to, vitamin E, tetrakis-(methylene-3-(3',5'-di-t-butyl-4'-hydroxyphenyl)propionate)methane, 2,5-di-t-butylhydroquinone, 2,6-di-t-butyl-p-cresol, 3,9-bis-{1,1-dimethyl-2-[3-(3-t-butyl-4-hydroxy-5-methylphenyl)propionyloxy]ethyl}-2,4,8,10-tetraoxaspiro(5,5)undecane, and 2-t-butyl-6-(3-t-butyl-2-hydroxy-5-methylbenzyl)-4-methylphenyl acrylate.

Other examples of the thermal polymerization inhibitor and the antioxidant include a phosphine-based material such as triphenyl phosphite.

The thermal polymerization inhibitor and the antioxidant may be used singly or in combinations of two or more thereof.

Examples of the light stabilizer and the ultraviolet ray absorber include, but are not limited to, known benzophenone-based, salicylate-based, acrylonitrile-based, metal complex-based, or hindered amine-based compounds.

The dye or pigment described below may also be used as the ultraviolet ray absorber.

Examples of such a light stabilizer and an ultraviolet ray absorber include, but are not limited to, 2-ethoxy-2'-ethyloxalic acid bisanilide, 2,2'-dihydroxy-4-methoxybenzophenone, bis(1,2,2,6,6-pentamethyl-4-piperidyl)-decanedioate, and 1,2,3-benzotriazole.

The dye or pigment is effective as coloring means for improving visibility.

Examples of the dye include, but are not limited to, a basic dye, an acid dye, and a direct dye, which are water-soluble, and a sulfur dye, an oil-soluble dye, and a disperse dye, which are non-water-soluble. Particularly, an anthraquinone-based dye, an indigoid-based dye, and an azo-based dye are preferable.

Examples of the pigment include, but are not particularly limited to, a natural pigment, a synthetic inorganic pigment, and a synthetic organic pigment. Examples of the synthetic organic pigment include an azo-based pigment, a triphenylmethane-based pigment, a quinoline-based pigment, an anthraquinone-based pigment, and a phthalocyanine-based pigment.

The photosensitive resin composition constituting the photosensitive resin composition layer can be produced by mixing the above-described materials, that is, the polymer (b-1), the ethylenically unsaturated compound (b-2), the photopolymerization initiator (b-3), and if necessary, an auxiliary additive component.

### <Support>

In the method for producing a printing plate according to the present embodiment, as shown in Figure 1, the support 3 is stacked on the above-described liquid photosensitive resin composition layer 2.

Examples of the support include, but are not limited to, a polyester film, a polyamide film, a polyacrylonitrile film, and a polyvinyl chloride film.

Among these, the support is preferably a polyester film.

Examples of the polyester used for the support include, but are not limited to, polyethylene terephthalate, polybutylene terephthalate, and polyethylene naphthalate.

The thickness of the support is not particularly limited, but is preferably 50 to 300 µm.

A predetermined adhesive layer may be provided on the support in order to enhance the adhesive force between the support and the above-described liquid photosensitive resin composition layer, which will be described later. Examples of the adhesive layer include, but are not particularly limited to, the adhesive layer described in International Publication No. WO 2004/104701, Japanese Patent No. 3094647, and Japanese Patent No. 2634429.

### (Exposure Step)

In the method for producing a printing plate according to the present embodiment, after the above-described stacking step, as shown in Figure 1, an exposure step is carried out in which irradiation with an active ray is performed from the first hard plate 11 side and the second hard plate 12 side to cure the photosensitive resin composition layer 2.

In the exposure from the first hard plate 11 side, the photosensitive resin composition layer 2 is irradiated with an active ray, such as ultraviolet ray, for pattern exposure using, as a mask, the negative film 1 on which a desired printing pattern and a microcell pattern have been drawn and processed. At this time, the light passing through the negative film 1 promotes a curing reaction in the photosensitive resin composition layer 2, and the printing pattern 1a and the microcell pattern 1b formed in the negative film 1 are transferred to the photosensitive resin composition layer 2 in which the convex and concave are inverted, thereby obtaining a pattern-exposed photosensitive resin composition layer.

In the method for producing a printing plate according to the present embodiment, from the viewpoint of mitigating the effects of refraction and scattering of the active ray with which the photosensitive resin composition layer is irradiated, the negative film 1 is disposed so that the pattern-drawn side surface is directly in contact with the liquid photosensitive resin composition layer 2.

In the exposure from the second hard plate 12 side, as necessary, the photosensitive resin composition layer is irradiated with the active ray using, as a mask, the negative film for back exposure 4 having a desired pattern for forming a shelf layer, thereby forming a shelf layer 5. For example, in the case of preparing a flexographic printing plate (having a thickness of 4 mm or more) for use in cardboard printing, it is preferable for supplementing the strength of a relief against a printing pressure at the time of printing to form a base shelf layer 5 on the upper second hard plate 12 side.

Instead of using the negative film for back exposure 4, back exposure may be carried out in which a uniform thin cured resin layer (back deposition layer) is deposited on the whole surface from the second hard plate 12 side.

The back deposition layer and the shelf layer are both formed by curing the photosensitive resin composition layer on a side opposite to the printing pattern-formed side of the photosensitive resin composition layer. The photosensitive resin composition layer becomes the back deposition layer when cured on the whole surface on the support side, and becomes the shelf layer when partially cured depending on the position of the printing pattern.

The active ray irradiation method is not particularly limited, and can be carried out using a known irradiation unit. The wavelength of ultraviolet ray in the irradiation is preferably 150 to 500 nm, and more preferably 300 to 400 nm.

The light source is not limited, but, for example, a low-pressure mercury lamp, a high-pressure mercury lamp, an ultrahigh-pressure mercury lamp, a metal halide lamp, a xenon lamp, a zirconium lamp, a carbon arc lamp, and a fluorescent lamp for ultraviolet ray can be used.

### (Developing Step)

In the method for producing a printing plate according to the present embodiment, after the exposure step, a development step is carried out in which an unexposed portion of the photosensitive resin composition layer is removed.

The method for removing the unexposed portion is not particularly limited, and a conventionally known method can be applied.

Specific methods include, for example, a method in which the photosensitive resin composition layer 2 is exposed and then the unexposed portion is washed away with a solvent for solvent development or a washing solution for water development, or a method in which the unexposed portion is brought into contact with a predetermined absorbing layer capable of absorbing it, and then the absorbing layer is removed to remove the unexposed portion. In a step previous to removal, the unexposed portion may be removed in advance using a spatula or a roll. If necessary, a post-exposure treatment is then performed, and a printing plate is obtained.

### (Recovery Step for Photosensitive Resin Composition of Unexposed Portion)

In the method for producing a printing plate according to the present embodiment, it is preferable that the method further includes a recovery step of recovering the unexposed portion removed in the developing step for use as a photosensitive resin composition for producing a new printing plate. The recovered photosensitive resin composition can be recycled as a photosensitive resin composition for the production of a new printing plate.

Use of the recovered photosensitive resin composition permits waste reduction as well as reduction in material cost.

On the other hand, if the ablation layer is eluted and/or migrated in a large amount into the recovered photosensitive resin composition, various inconveniences such as scattering of active ray may occur in the printing plate production step using the recovered photosensitive resin composition, and the quality of the finally obtained printing plate may be impaired.

According to the method for producing a printing plate according to the present embodiment, elution and/or migration of the ablation layer to the photosensitive resin composition layer can be suppressed in the finally obtained printing plate, and thus the photosensitive resin composition with quality comparable to the unused state can be recovered at a high yield. Therefore, it is possible to maintain quality, such as improved open depth, in a new printing plate produced using the recovered photosensitive resin composition.

In detail, the method for producing a printing plate according to the present embodiment has the following effects (1) to (4).
(1) Elution and migration of the negative film to the photosensitive resin composition layer can be suppressed.
(2) A printing plate on which microcells can be formed and that has high solid density and excellent image reproducibility can be produced.
(3) The unexposed photosensitive resin composition with reduced deterioration and contamination can be removed and recovered. This can prevent the degradation of the photosensitive resin composition, and the photosensitive resin composition of high quality can be recycled at a high yield.
(4) In the developing step, impurities can be suppressed from being mixed into the unexposed photosensitive resin composition, allowing a wide range of developing methods to be selected.

### Examples

Hereinafter, the present embodiment will be described more specifically with reference to specific Examples and Comparative Examples, but the present invention is not limited to the following examples by any means.

In Examples and Comparative Examples described later, flexographic printing plates were prepared, and evaluation was performed on elution and migration of the negative film to the photosensitive resin composition, and on the solid density of the flexographic printing plates.

### [Production of Negative Film for Flexographic Printing Plate Production]

As described below, negative films 1 to 5 for flexographic printing plate production were prepared.

### (Preparation of Negative Film 1)

### <Production of Resin 1 for Negative Film 1>

After purging the inside of a 2-L separable flask polymerization vessel with nitrogen, 456.1 mL of n-hexane (dried with molecular sieves) and 656.5 mL of butyl chloride (dried with molecular sieves) are added using a syringe, and the polymerization vessel was cooled by placing it in a dry ice/methanol bath at -70°C. Thereafter, a Teflon (R) feed tube was connected to a pressure-resistant glass liquefaction collection tube with a three-way stopcock containing 161.1 g (2871 mmol) of isobutylene monomer, and the isobutylene monomer was pumped into the polymerization vessel by nitrogen pressure. 0.647 g (2.8 mmol) of p-dicumyl chloride and 1.22 g (14 mmol) of N,N-dimethylacetamide were added. Next, 8.67 mL (79.1 mmol) of titanium tetrachloride was further added to initiate polymerization.

After performing stirring at the same temperature for 1.5 hours from the initiation of polymerization, about 1 mL of the polymerization solution was withdrawn from the polymerization solution for sampling.

Subsequently, a mixed solution of 77.9 g (748 mmol) of styrene monomer, 23.9 mL of n-hexane, and 34.3 mL of butyl chloride, which had been cooled to -70°C in advance, was added into the polymerization vessel. About 40 mL of methanol was added 45 minutes after the addition of the mixed solution to terminate the reaction, affording a reaction solution.

Solvents and other materials were distilled off from the reaction solution, which was then dissolved in toluene and washed twice with water. Furthermore, the toluene solution was added to a large amount of methanol to precipitate the polymer, and the resulting polymer was vacuum-dried at 60°C for 24 hours to obtain a resin 1.

The content proportion of styrene was determined by ¹H-NMR to be 30% by mass.

### <Production of Film 1 for Flexographic Printing Plate Production>

6.5 parts by mass of the resin 1 prepared as described above, 54.0 parts by mass of toluene, and 36.0 parts by mass of cyclohexanone were mixed, and the resin 1 was dissolved in the solvent.

Thereafter, 3.5 parts by mass of carbon black (manufactured by Mitsubishi Chemical Corporation, #1000) was further charged, and the mixture was then mixed for 4 hours using a bead mill to obtain a carbon black dispersion.

A base material made of polypropylene with a thickness of 50 µm (PYLEN P3162, manufactured by Toyobo Co., Ltd.) was coated with the carbon black dispersion obtained as described above so that the film thickness after drying was 2.5 µm. A drying treatment at 90°C for 2 minutes was performed to obtain a film 1 for flexographic printing plate production, which was a stack of the ablation layer and the base material.

### <Laser Drawing on Film 1 for Flexographic Printing Plate Production>

The film 1 for flexographic printing plate production was placed on ESKO CDI Crystal 5080, and laser drawing was performed on the ablation layer in the MCWSI pattern under conditions of a resolution of 4000 dpi and a laser intensity of 2.4 J, thereby obtaining a negative film 1 on which a printing pattern having a microcell pattern had been formed.

### (Preparation of Negative Film 2)

Laser ablation was performed without using a microcell pattern, with other conditions being the same as those for the negative film 1, thereby obtaining a negative film 2 having a solid pattern. In Table 1 below, this was denoted as "Solid No MC".

### (Preparation of Negative Film 3)

### <Production of Film 2 for Flexographic Printing Plate Production>

6.5 parts by mass of a butyral resin (PVB resin, Mowital B30H manufactured by Kuraray Co., Ltd.), 54.0 parts by mass of ethanol, and 36.0 parts by mass of 1-butanol were mixed, and Mowital B30H was dissolved in the solvent.

Thereafter, 3.5 parts by mass of carbon black (manufactured by Mitsubishi Chemical Corporation, #1000) was further charged, and the mixture was then mixed for 4 hours using a bead mill to obtain a carbon black dispersion.

A base material made of polypropylene with a thickness of 50 µm (PYLEN P3162, manufactured by Toyobo Co., Ltd.) was coated with the carbon black dispersion obtained as described above so that the film thickness after drying was 2.5 µm. A drying treatment at 90°C for 2 minutes was performed to obtain a film 2 for flexographic printing plate production, which was a stack of the ablation layer and the base material.

### <Laser Drawing on Film 2 for Flexographic Printing Plate Production>

The film 2 for flexographic printing plate production was placed on ESKO CDI Crystal 5080, and laser drawing was performed on the ablation layer in the MCWSI pattern at a resolution of 4000 dpi and a laser intensity of 3.4 J, thereby obtaining a negative film 3 on which a printing pattern having a microcell pattern had been formed.

### (Preparation of Negative Film 4)

Laser ablation was performed without using a microcell pattern, with other conditions being the same as those for the negative film 3, thereby obtaining a negative film 4 having a solid pattern. In Table 1 below, this was denoted as "Solid No MC".

### (Preparation of Negative Film 5)

The NX film (manufactured by Miraclon, FLEXCEL NX Thermal Imaging Layer) was placed on Kodak Flexcel Wide-C imager, and laser drawing was performed at a resolution of 2400 dpi in the Digicap Standard pattern.

### [Photosensitive Resin Composition]

As photosensitive resin compositions for flexographic printing plate production, the following were used.
Photosensitive resin composition 1 produced as described below
Photosensitive resin composition 2 produced as described below

### (Preparation of Polymer for Photosensitive Resin Composition)

In order to prepare the photosensitive resin composition, at first, polymers 1 and 2 were prepared as the polymer (b-1).

### (Polymer 1)

1200 g of poly(3-methyl-1,5-pentanediol adipate) diol ("Kurapol P3010" manufactured by Kuraray Co., Ltd.) and 800 g of polyoxyethylene (EO)-oxypropylene (PO) block copolymer diol ("SUNNIX PL2100" manufactured by Sanyo Chemical Industries, Ltd.) as diols, and 0.03 g of dibutyltin dilaurate were added, and stirred at 40°C until homogeneous to obtain a mixture.

To the obtained mixture, 137 g of tolylene diisocyanate ("CORONATE T80" manufactured by Tosoh Corporation) was added, and stirred until homogeneous to obtain a mixture.

After becoming homogeneous, the mixture was heated to 80°C and then reacted for 4 to 5 hours to prepare a prepolymer precursor having isocyanate groups at both ends.

To the obtained prepolymer precursor, 387 g of poly(oxypropylene) glycol monomethacrylate ("Blemmer PP" manufactured by NOF Corporation) was added as a (meth)acrylating agent and reacted for 2 hours to obtain a reaction product.

A portion of the obtained reaction product was isolated and subjected to IR spectrometry to confirm the disappearance of the isocyanate groups.

As described above, the polymer 1 was obtained.

### (Polymer 2)

1300 g of polyoxyethylene (EO)-oxypropylene (PO) block copolymer diol ("SANNIX PL2100" manufactured by Sanyo Chemical Industries, Ltd.) and 750 g of 2,4-diethyl-1,5-pentanediol/adipic acid polycondensate ("HS2N-521A" manufactured by Hokoku Corporation) as diols, and 0.02 g of dibutyltin dilaurate were added, and stirred at 40°C until homogeneous to obtain a mixture.

To the obtained mixture, 145 g of tolylene diisocyanate ("CORONATE T80" manufactured by Tosoh Corporation) was added, and stirred until homogeneous to obtain a mixture.

After becoming homogeneous, the mixture was heated to 80°C and then reacted for 4 to 5 hours to prepare a prepolymer precursor having isocyanate groups at both ends.

To the obtained prepolymer precursor, 370 g of polyoxypropylene monoacrylate ("PPM" manufactured by NOF Corporation) was added as a (meth)acrylating agent and reacted for 2 hours to obtain a reaction product.

A portion of the obtained reaction product was isolated and subjected to IR spectrometry to confirm the disappearance of the isocyanate groups.

As described above, the polymer 2 was obtained.

### (Preparation of Photosensitive Resin Composition)

Using the polymer 1 and the polymer 2 obtained as described above, photosensitive resin compositions were prepared.

The photosensitive resin composition constituting the photosensitive resin composition layer was produced by mixing the polymer 1 and the polymer 2 prepared as described above, the ethylenically unsaturated compound (b-2), the photopolymerization initiator (b-3), and auxiliary additive components.

By using the polymer 1, a photosensitive resin composition 1 was prepared, and by using the polymer 2, a photosensitive resin composition 2 was prepared as described below.

### <Photosensitive Resin Composition 1>

68.2 parts by mass of the above-described polymer 1, 21.8 parts by mass of diethylene glycol (2-ethylhexyl) ether acrylate ("ARONIX M-120" manufactured by Toagosei Co., Ltd.) as the ethylenically unsaturated compound (b-2), 1.1 parts by mass of trimethylolpropane trimethacrylate ("NK Ester TMPT" manufactured by Shin-Nakamura Chemical Co., Ltd.) as the component (b-2), 6.3 parts by mass of dibutyl sebacate ("DBS" manufactured by Hokoku Corporation) as a plasticizer, 1.0 parts by mass of 2,2-dimethoxy-2-phenylacetophenone ("IRGACURE 651" manufactured by Ciba Specialty Chemicals) as the photopolymerization initiator (b-3), and 1.6 parts by mass of 2,6-di-t-butyl-p-cresol ("IONOL" manufactured by Oxalis Chemicals Ltd.) as an antioxidant were added, and the mixture was stirred and mixed in a heated state at 60°C, thereby obtaining a photosensitive resin composition.

### <Photosensitive Resin Composition 2>

65.6 parts by mass of the above-described polymer 2, 20.2 parts by mass of 2-(diethylamino)ethyl methacrylate ("Methacrylic Ester DE" manufactured by Mitsubishi Chemical Corporation) as the ethylenically unsaturated compound (b-2), 7.0 parts by mass of butoxydiethylene glycol methacrylate ("Light Ester AK-8" manufactured by Kyoeisha Chemical Co., Ltd.) as the (b-2) component, 5.8 parts by mass of dibutyl sebacate ("DBS" manufactured by Hokoku Corporation) as a plasticizer, 1.2 parts by mass of benzophenone ("Benzophenone" manufactured by Daiki Fine Chemical Co., Ltd.) as the photopolymerization initiator (b-3), and 1.8 parts by mass of bis(1,2,2,6,6-pentamethyl-4-piperidyl)=decanedioate (HS Ester 765 manufactured by Hokoku Corporation) as an antioxidant were each added, and the mixture was stirred and mixed in a heated state at 60°C, thereby obtaining a photosensitive resin composition 2.

### [Physical Properties of Negative Film and Photosensitive Resin Composition] (Sp Value (SpB) of Negative Film and Sp Value (SpA) of Photosensitive Resin Composition)

The Sp value (SpB) of the negative film and the Sp value (SpA) of the photosensitive resin composition were measured by a cloud point titration method.

To a solution obtained by dissolving a sample for measurement in a good solvent with a known SP value, a poor solvent having an SP value lower than that of the good solvent was added dropwise, and the volume of the poor solvent at which the solute started to precipitate was measured. Subsequently, to a newly prepared solution obtained by dissolving the sample with an unknown SP value in the good solvent with a known SP value, a poor solvent having an SP value higher than that of the good solvent was added dropwise, and the volume of the poor solvent at which the solute started to precipitate was measured. By applying the respective volumes of the poor solvents determined here to the following expression (2), an SP value (δ) was determined: $SP value \left(δ\right) = \left({{V}_{ml}}^{1 / 2}⋅{δ}_{ml}+{{V}_{mh}}^{1 / 2}⋅{δ}_{mh}\right) / \left({{V}_{ml}}^{1 / 2}+{{V}_{mh}}^{1 / 2}\right)$ (2).

Here, Vₘₗ is the volume of the poor solvent having a lower SP value, Vₘₕ is the volume of the poor solvent having a higher SP value, δₘₗ is the SP value of the poor solvent having a lower SP value, and δₘₕ is the SP value of the poor solvent having a higher SP value.

The calculation was performed using the following good solvents and poor solvents, and their respective SP values.

### Good solvents:

toluene (SP value: 8.9 [(cal/cm³)^{1/2}])
p-xylene (SP value: 8.7 [(cal/cm³)^{1/2}])
butyl acetate (SP value: 8.5 [(cal/cm³)^{1/2}])
ethyl acetate (SP value: 9.1 [(cal/cm³)^{1/2}])
acetone (SP value: 9.8 [(cal/cm³)^{1/2}])

### Poor solvents:

n-hexane (SP value: 7.2 [(cal/cm³)^{1/2}])
ethanol (SP value: 12.9 [(cal/cm³)^{1/2}])
water (SP value: 23.4 [(cal/cm³)^{1/2}])

### [Characteristic Evaluation in Production of Printing Plate]

### (Solid Density)

The solid density of printed matter was measured and evaluation was performed thereon.

Using the flexographic printing plates prepared in the Examples and Comparative Examples described later, indigo ink was printed on a transparent PET film.

The pressure from the anilox roll to the flexographic printing plate, and the printing pressure from the flexographic printing plate to the transparent film, as well as the printing machine hardware, tools, software, operational configuration, and the handling, cleaning, surface treatment, and mounting of the flexographic printing plate and the transparent PET film, were carried out under standard industrial production printing conditions.

The printing machine was the AI-3 type flexographic printing press (manufactured by Iyokikai Seisakusho) operated at 100 m/min, and the ink was Hydric FCF739 (manufactured by Dainichiseika Color & Chemicals Mfg. Co., Ltd.) having a viscosity of 12 seconds as measured with a Zahn cup #4.

The transparent PET film used was R8150 Cycle Clean with a width of 330 mm and a thickness of 12 µm (manufactured by Toyobo Co., Ltd.).

The anilox roll used was apex 860 lpi 5.1 cc, and the liquid plate was mounted using DuploFLEX 5.2+ tape (manufactured by Lohmann GmbH & Co. KG).

Next, the reflectance of the printed matter was measured, and the solid density was calculated.

For the reflectance, the eXact Standard, which involves measurement of the reflectance optical density and measurement by standard measurement carried out using a reflection densitometer (commonly used instrument in the field of graphic arts), was applied. The measurement conditions for the solid density were: color-related value: no filter; density-related value: no filter; density color: Cyan.

A solid density of 1.40 or more was evaluated as practically good.

### (Evaluation of Elution and Migration of Negative Film to Photosensitive Resin Composition Layer)

Elution and migration of the negative film to the photosensitive resin composition layer in the flexographic printing plates prepared in the Examples and Comparative Examples described later were evaluated by the following method.

Each negative film was placed in a vial filled with the photosensitive resin composition, left standing overnight in a thermostatic chamber at 30°C, and evaluated according to the evaluation criteria described below. If the evaluation was A to B, it was considered that the flexographic printing plate could be practically used without problems.

### <Evaluation Criteria>

A: No detachment of the ablation layer was observed, and no contamination of the photosensitive resin composition occurred. Moreover, it could not be removed even when rubbed with a spatula.
B: No detachment of the negative film or contamination occurred unless force was applied with a spatula or the like, but the ablation layer detached when rubbed with a spatula.
C: Detachment of the ablation layer or contamination of the photosensitive resin composition was observed.

### [Production of Printing Plate]

### (Example 1)

Using the photosensitive resin composition 1 as the photosensitive resin composition and the negative film 1, a flexographic printing plate was prepared through a molding and exposure step, a developing step, a post-exposure step, and a drying step sequentially, as described below.

### <(1) Molding and Exposure Step>

Molding and Exposure were performed by (A1) to (A3) using the "ALF-213E plate maker" manufactured by Asahi Kasei Corporation.

### (A1):

The negative film 1 after image drawing was placed on an ultraviolet transmitting lower glass plate so that the ablation layer after image drawing was positioned on the opposite side of the lower glass plate with the base material in between. Thereafter, without carrying out the step of stacking a cover film on the ablation layer (hereinafter, this step is referred to as insertion part step), the negative film 1 was fixed by vacuuming with a pump through a groove provided around the lower glass.

By pouring the liquid photosensitive resin composition on the negative film 1, laminating the resultant with a base film serving as a support via a spacer so as to attain a constant plate thickness, mounting a negative film for back exposure on the base film, and further pressing an ultraviolet transmitting glass plate (upper glass plate) thereagainst, a liquid photosensitive resin composition layer was formed.

### (A2):

The photosensitive resin composition layer thus formed was irradiated with active ray with an active light source such as an ultraviolet fluorescent lamp (ray having a wavelength distribution at 300 nm or more) via the base film from the upper glass plate side to carry out back exposure.

### (A3):

After the back exposure step, there was performed a relief forming exposure step of irradiating the photosensitive resin composition layer with the same active ray as in the upper glass plate side via the negative film 1 after image drawing from the lower glass plate side to perform image formation, thereby obtaining an original flexographic printing plate.

As described above, the photosensitive resin composition layer was formed in (A1).

Subsequently, the photosensitive resin composition layer was exposed in (A2) and (A3) to obtain an original flexographic printing plate having a plate thickness of 1.7 mm and a relief depth of 0.6 mm. In this context, the relief depth is a conventional term that expresses a length determined by subtracting the height of the shelf layer from a plate thickness, i.e., the depth of a printed image relief.

The dose of back exposure was appropriately adjusted in order to adjust the relief depth.

Relief formation was performed under the exposure condition with a dose of relief exposure of 600 mJ/cm².

### <(2) Developing Step>

The negative film 1 after image drawing was peeled off from the original flexographic printing plate, and the unexposed resin was collected and removed from the original flexographic printing plate using a rubber spatula. Thereafter, there was prepared, as the developing solution that is capable of emulsifying the photosensitive resin composition, an aqueous solution containing 2% by mass of "APR(R) washing agent type W-10" (main agent: anionic surfactant) manufactured by Asahi Kasei Corporation, 0.5% by mass of "APR(R) surface treatment agent type A-10" (main agent: nonionic surfactant, benzophenone) manufactured by Asahi Kasei Corporation, and 0.3% by mass of "antifoaming agent SH-4" (silicone mixture) manufactured by Asahi Kasei Corporation in "AL-400W developing machine" manufactured by Asahi Kasei Corporation (a drum rotary spray system, the number of drum rotations: 20 rpm, spray pressure: 0.15 Pa), and the development was performed under conditions involving a liquid temperature of 40°C and a development time of 10 minutes.

The plate thus developed was washed to the extent that foam from the developing solution was rinsed off with tap water.

### <(3) Post Exposure Step>

Post exposure was performed by an in-water exposure scheme using "AL-200UP post exposure machine" manufactured by Asahi Kasei Corporation which has both an ultraviolet fluorescent lamp and a germicidal lamp.

The exposure was performed for an exposure time such that the dose of irradiation from each light source was 2000 mJ/cm² (ultraviolet fluorescent lamp) and 2000 mJ/cm² (germicidal lamp) on the surface of the photosensitive resin composition.

### <(4) Drying Step>

The plate thus post-exposed was dried for about 30 minutes using "ALF-DRYER" manufactured by Asahi Kasei Corporation until water disappeared from the surface to obtain a flexographic printing plate of Example 1.

### (Example 2)

The negative film 3 was used.

The other conditions were the same as those described above (Example 1), and a flexographic printing plate was prepared.

### (Example 3)

As the photosensitive resin composition, the photosensitive resin composition 2 was used.

The other conditions were the same as those described above (Example 1), and a flexographic printing plate was prepared.

### (Example 4)

The negative film 3 was used.

As the photosensitive resin composition, the photosensitive resin composition 2 was used.

The other conditions were the same as those described above (Example 1), and a flexographic printing plate was prepared.

### (Comparative Example 1)

The negative film 2 was used.

The other conditions were the same as those described above (Example 1), and a flexographic printing plate was prepared.

### (Comparative Example 2)

The insertion part step of stacking a cover film (CF-92 manufactured by Asahi Kasei Corporation) on the ablation layer was conducted.

The other conditions were the same as those described above (Example 1), and a flexographic printing plate was prepared.

### (Comparative Example 3)

The negative film 5 was used.

The other conditions were the same as those described above (Example 1), and a flexographic printing plate was prepared.

### (Comparative Example 4)

The negative film 5 was used.

The insertion part step of stacking a cover film (CF-92 manufactured by Asahi Kasei Corporation) on the ablation layer was conducted.

The other conditions were the same as those described above (Example 1), and a flexographic printing plate was prepared.

### (Comparative Example 5)

The negative film 4 was used.

The other conditions were the same as those described above (Example 1), and a flexographic printing plate was prepared.

### (Comparative Example 6)

The negative film 3 was used.

The insertion part step of stacking a cover film (CF-92 manufactured by Asahi Kasei Corporation) on the ablation layer was conducted.

The other conditions were the same as those described above (Example 1), and a flexographic printing plate was prepared.

### (Comparative Example 7)

The negative film 2 was used.

As the photosensitive resin composition, the photosensitive resin composition 2 was used.

The other conditions were the same as those described above (Example 1), and a flexographic printing plate was prepared.

### (Comparative Example 8)

The negative film 5 was used.

As the photosensitive resin composition, the photosensitive resin composition 2 was used.

The other conditions were the same as those described above (Example 1), and a flexographic printing plate was prepared.

**[Table 1]**

| Example | Photosensitive resin composition type | SpA | Negative film type | Film type | Pattern | SpB | ΔSp value (absolute value) | Cover film | Elution / migration | Solid density |
|---|---|---|---|---|---|---|---|---|---|---|
| Example 1 | Photosensitive resin composition 1 | 11.1 | Negative film 1 | Film 1 for flexographic printing plate production | MCWSI | 8.6 | 2.5 | Absent | B | 1.53 |
| Example 2 | Photosensitive resin composition 1 | 11.1 | Negative film 3 | Film 2 for flexographic printing plate production | MCWSI | 17.2 | 6.1 | Absent | A | 1.51 |
| Example 3 | Photosensitive resin composition 2 | 10.9 | Negative film 1 | Film 1 for flexographic printing plate production | MCWSI | 8.6 | 2.3 | Absent | B | 1.48 |
| Example 4 | Photosensitive resin composition 2 | 10.9 | Negative film 3 | Film 2 for flexographic printing plate production | MCWSI | 17.2 | 6.3 | Absent | A | 1.47 |
| Comparative Example 1 | Photosensitive resin composition 1 | 11.1 | Negative film 2 | Film 1 for flexographic printing plate production | Solid No MC | 8.6 | 2.5 | Absent | B | 1.33 |
| Comparative Example 2 | Photosensitive resin composition 1 | 11.1 | Negative film 1 | Film 1 for flexographic printing plate production | MCWSI | 8.6 | 2.5 | Present | A | 1.45 |
| Comparative Example 3 | Photosensitive resin composition 1 | 11.1 | Negative film 5 | FLEXCEL NX Thermal Imaging Layer | Standard | 12.1 | 1.0 | Absent | C | Not printable |
| Comparative Example 4 | Photosensitive resin composition 1 | 11.1 | Negative film 5 | FLEXCEL NX Thermal Imaging Layer | Standard | 12.1 | 1.0 | Present | A | 1.33 |
| Comparative Example 5 | Photosensitive resin composition 1 | 11.1 | Negative film 4 | Film 2 for flexographic printing plate production | Solid No MC | 17.2 | 6.1 | Absent | A | 1.27 |
| Comparative Example 6 | Photosensitive resin composition 1 | 11.1 | Negative film 3 | Film 2 for flexographic printing plate production | MCWSI | 17.2 | 6.1 | Present | A | 1.33 |
| Comparative Example 7 | Photosensitive resin composition 2 | 10.9 | Negative film 2 | Film 1 for flexographic printing plate production | Solid No MC | 8.6 | 2.3 | Absent | B | 1.25 |
| Comparative Example 8 | Photosensitive resin composition 2 | 10.9 | Negative film 5 | FLEXCEL NX Thermal Imaging Layer | Standard | 12.1 | 1.2 | Absent | C | Not printable |

As shown in Table 1, in the Examples, there was no elution or migration of the ablation layer to the photosensitive resin composition, and flexographic printing plates having a high solid density were obtained.

The present application is based on Japanese Patent Application No. 2023-220270 filed with the Japan Patent Office on December 27, 2023, the contents of which are incorporated herein by reference.

### Industrial Applicability

The present invention has industrial applicability in wide general commercial printing fields.

### Reference Signs List

1 negative film
1a printing pattern
1b microcell pattern
2 photosensitive resin composition layer
2b microcell
2a pattern
3 support
4 negative film for back exposure
4a shelf layer forming pattern
5 shelf layer
11 first hard plate
12 second hard plate
21 base material
22 ablation layer

## Claims

1. A method for producing a printing plate, comprising:
a stacking step of sequentially stacking, on a first hard plate positioned below, a negative film having a microcell pattern, a liquid photosensitive resin composition layer, a support, and a second hard plate positioned above; and
an exposure step of performing irradiation with an active ray from the first hard plate side and the second hard plate side to cure the photosensitive resin composition layer,
wherein, in the stacking step, the photosensitive resin composition layer is directly stacked on the negative film, and
wherein a solubility parameter SpA of a photosensitive resin composition constituting the photosensitive resin composition layer and a solubility parameter SpB of the negative film have a relationship of the following expression (I): $\left|SpA-SpB\right| \geq 2.0$ (I).

2. The method for producing a printing plate according to claim 1,
wherein the method further comprises, as a step preceding the stacking step, a drawing step of forming a microcell pattern on the negative film, and
wherein, in the drawing step, at least one selected from the group consisting of an ablation method, a thermal method, an ink jet method, and a silver salt method is used.

3. The method for producing a printing plate according to claim 1,
wherein a solubility parameter SpA of a photosensitive resin composition constituting the photosensitive resin composition layer is 10.0 or more and 14.0 or less.

4. The method for producing a printing plate according to claim 1,
wherein a solubility parameter SpB of the negative film is more than 14.0.

5. The method for producing a printing plate according to claim 1,
wherein a solubility parameter SpB of the negative film is less than 10.0.

6. The method for producing a printing plate according to claim 1,
wherein the negative film contains a resin having a constituent unit represented by the following general formula (II): 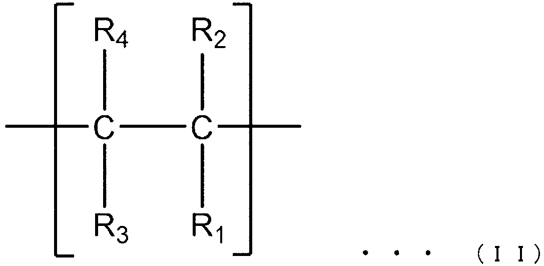 wherein, in the formula (II), R₁ and R₂ each independently represent a non-polar group, and R₃ and R₄ each independently represent a hydrogen atom or a non-polar group.

7. The method for producing a printing plate according to claim 6, wherein
in the formula (II), R₁ and R₂ each independently represent any one selected from the group consisting of an alkyl group, an alkenyl group, and an alkynyl group, and
R₃ and R₄ are each independently any one selected from the group consisting of a hydrogen atom, an alkyl group, an alkenyl group, and an alkynyl group.

8. The method for producing a printing plate according to claim 6,
wherein, in the formula (II), R₁ and R₂ are each independently an alkyl group, and
R₃ and R₄ are each independently a hydrogen atom or an alkyl group.

9. The method for producing a printing plate according to claim 6,
wherein the resin having a constituent unit represented by the general formula (II) further has a constituent unit derived from a monovinyl-substituted aromatic hydrocarbon.

10. The method for producing a printing plate according to claim 1,
wherein the negative film comprises at least one selected from the group consisting of polyurethane, polylactic acid, polycarbonate, polyester, polyamide, polybutyral, polyvinyl alcohol, poly(meth)acrylate, and modified products or partially saponified products thereof.

11. The method for producing a printing plate according to claim 1,
wherein the method comprises, as a step succeeding the exposure step, a developing step of removing an unexposed portion of the photosensitive resin composition layer, and
wherein the method further comprises a recovery step of recovering the unexposed portion removed in the developing step for use as a photosensitive resin composition for producing a new printing plate.

12. A method for producing a printing plate, comprising:
a stacking step of sequentially stacking, on a first hard plate positioned below, a negative film having a microcell pattern, a liquid photosensitive resin composition layer, a support, and a second hard plate positioned above; and
an exposure step of performing irradiation with an active ray from the first hard plate side and the second hard plate side to cure the photosensitive resin composition layer,
wherein, in the stacking step, the photosensitive resin composition layer is directly stacked on the negative film, and
wherein a solubility parameter SpB of the negative film is 13.0 or more.

13. A method for producing a printing plate, comprising:
a stacking step of sequentially stacking, on a first hard plate positioned below, a negative film having a microcell pattern, a liquid photosensitive resin composition layer, a support, and a second hard plate positioned above; and
an exposure step of performing irradiation with an active ray from the first hard plate side and the second hard plate side to cure the photosensitive resin composition layer,
wherein, in the stacking step, the photosensitive resin composition layer is directly stacked on the negative film, and
wherein a solubility parameter SpB of the negative film is 9.0 or less.
